# EUROPEAN PATENT SPECIFICATION

(11) **EP 2 532 767 B1**
(45) Date of publication and mention of the grant of the patent: **15.03.2017**
(21) Application number: 12171360.6
(22) Date of filing: 08.06.2012
(51) Int. Cl.: C23C 16/30, C23C 16/455

(54) **Process for making a ternary metal chalcogenide film,**
Verfahren zur Herstellung einer Schicht eines Ternär-Metallchalcogenids
Procédé de fabrication d'une couche d'un chalcogénure métallique ternaire

(30) Priority: 09.06.2011 US 201113156501
(43) Date of publication of application: 12.12.2012
(73) Proprietor: AIR PRODUCTS AND CHEMICALS, INC., Allentown, PA 18195-1501 (US)
(72) Inventor: Xiao, Manchao, San Diego, CA California 92130 (US); Lei, Xinjian, Vista, CA California 92081 (US); Yang, Liu, Yorba Linda, CA California 92886 (US)
(74) Representative: Beck Greener

(56) References cited:
- EP-A2- 2 130 942
- US-A1- 2009 097 305
- US-A1- 2009 112 009

## Description

### BACKGROUND OF THE INVENTION

Binary, ternary, and quaternary metal chalcogenides have been used as phase change and photovoltaic materials.

Phase-change materials exist in a crystalline state or an amorphous state according to temperature. A phase-change material has a more ordered atomic arrangement and a lower electrical resistance in a crystalline state than in an amorphous state. A phase-change material can be reversibly transformed from the crystalline state to the amorphous state based on an operating temperature. Such characteristics, that is, reversible phase change and different resistances of different states, are applied to newly proposed electronic devices, a new type of nonvolatile memory devices, phase-change random access memory (PRAM) devices. The electrical resistance of a PRAM device may vary based on a state (e.g., crystalline, amorphous, etc.) of a phase-change material included therein.

Among various types of phase-change materials used for memory devices, the most commonly used are ternary chalcogenides of group 14 and group 15 elements, such as germanium-antimony-tellurium (commonly abbreviated as GST) compounds. Importantly, a phase-change material with a composition of Ge₂Sb₂Te₅ has proven to be the best candidate. The solid phases of GST can rapidly change from crystalline state to amorphous state or vise versa upon heating and cooling cycles. The amorphous GST has relatively higher electrical resistance while the crystalline GST has relatively lower electrical resistance.

Previous arts include the manufacturing of bulk metal chalcogenide phase change materials with metallurgical methods and thin film materials with Physical Vapor Deposition (PVD), chemical vapor deposition (CVD) or atomic layer deposition (ALD) processes. Examples of works in the field are listed below.

Berger, H. and Goetze, U. disclose the preparation of disilyltellurides (Inorg. Nucl. Chem. Lett.1967 , 3 , 549-552). Detty, Michael R. and Seidler, Mark D. disclose the synthesis of bis(trialkylsilyl) chalcogenides (Journal of Organic Chemistry (1982), 47(7), 1354-6). Dickson, R.S. and Heazle, K. D. disclose the assessment of some Sb-Te single-source compounds for MOCVD applications (J. Organometal. Chem., 493 (1995) 189-197). Choi, B.J., et al, disclose the deposition of Ge2Sb2Te5 films in cyclic PECVD process using metallorganic precursors (J. Electrochemical Soc., 154 H318-H324 (2007)). Jung-Hyun Lee, et al, disclose the making of GST films from aminogermanes, aminostilbines, and dialkyltellurium (US 2006 0172083 A1); disclose tellurium precursors for GST films (US 2006 0180811); and disclose antimony precursors for GST films (US 2006 0049447). Duncan W. Rown, et al, disclose the use of organometallic tellurium compounds using fluorinated alkyl tellurium compounds in CVD process (US 5312983). Moungi G. Bawendi, et al, disclose tellurium-containing nanocrystalline materials produced by injection of a precursor into a hot coordinating solvent, followed by controlled growth and annealing (US 7060243 B2).

Further CVD methods for depositing GST are disclosed in EP-A-2 130 942, US 2009/0097305 A1 and US2009/0112009 A1.

One of the technical hurdles in designing a PRAM cell is that in order to overcome the heat dissipation during the switching of GST materials from crystalline to amorphous states a high level of reset current has to be applied. This heat dissipation, however, can be greatly reduced by confining GST material into contact plugs, thus reducing the reset current needed for the action. Since the GST contact plugs are of high aspect ratio structure, conventional sputtering process for GST film deposition can not achieve high comformality. This drives the need for precursors and related manufacturing methods or processes for forming GST films by chemical vapor deposition (CVD) or atomic layer deposition (ALD) processes, which can produce films with high conformality and chemical composition uniformity.

Similarly, precursors and related manufacturing processes are needed for making thin films of photovoltaic (PV) materials for applications such as the solar cells. A photovoltaic (PV) device absorbs light and generates electricity. The absorption of light and separation of charges happen in the active materials in a PV device. Development of efficient and low cost photovoltaic devices is key to significant utility of direct solar energy to electrical power conversion. Crystalline silicon is among the best-known semiconductors for photovoltaic devices and is widely employed. Other useful materials are thin films of amorphous silicon (a-Si), Copper Indium Selenide (CIS), Copper Gallium Selenide(CGS), Polycrystalline Copper Indium Gallium Selenide (CIGS), Cadmium telluride (CdTe), and organic material. The elements useful are cadmium, tellurium, indium, gallium, selenium, germanium and ruthenium.

### BRIEF SUMMARY OF THE INVENTION

The present invention satisfies the need by providing new sets of chemistry to manufacture metal chalcogenide materials in thin film form with CVD or ALD processes, or in fine particle form with wet chemistry processes.

According to one aspect, the present invetnion provides a process of making a metal chalcogenide alloy film on a substrate comprising:
contacting the substrate with a silyl-chalcogen selected from the group consisting of silyltelluriums and silylseleniums;
contacting the substrate with a germanium compound having a general formula selected from the group consisting of Ge(OR)₂, Ge(NR₂)₂ and combinations thereof;
   wherein each R is independently selected from the group consisiting of
   an alkyl group having 1 to 10 carbons in linear, branched or cyclic form, or an aromatic group; and
   a functionalized alkyl group with the general structure of:

   R⁵NR⁶R⁷;

   R⁵OR⁶; or

   R⁵SR⁶;

   wherein R⁵ is an alkylene group having 2 to 6 carbons in linear, branched or cyclic form, or an aromatic group; and R⁶⁻⁷ are each independently selected from the group consisting of hydrogen, alkyl groups having 1 to 6 carbons in linear, branched or cyclic form, and aromatic groups;
   and
contacting the substrate with a metal compound having a general formula of: MXₙ;
   wherein: M is selected from the group consisting of Sb, In, Sn, Ga, Bi, Ag, Cu, Zr, Hf, Hg, Cd, Zn and noble metals;
   X is a nucleophilic group selected from the group consisting of OR(alkoxy), F(fluorine), Cl (chlorine), Br (bromine), NR₂(amino), CN (cyano), OCN (cyanate), SCN (thiocyanate), diketonate, carboxylic groups and mixtures thereof; and n=1 to 5; wherein when n >1, each X is individually selected from selected from the group consisting of OR(alkoxy), F(fluorine), Cl (chlorine), Br (bromine), NR₂(amino), CN (cyano), OCN (cyanate), SCN (thiocyanate), diketonate, and carboxylic groups.

According to another aspect, the present provides an ALD process of making a metal chalcogenide alloy film on a substrate in an ALD reactor comprising steps of:
(a) contacting the substrate with a silyl-chalcogen selected from the group consisting of silyltelluriums and silylseleniums; and
(b) contacting the substrate with a germanium compound having a general formula selected from the group consisting of Ge(OR)₂, Ge(NR₂)₂ and combinations thereof;
   wherein each R is independently selected from the group consisiting of an alkyl group having 1 to 10 carbons in linear, branched or cyclic form, or an aromatic group; and
   a functionalized alkyl group with the general structure of:

   R⁵NR⁶R⁷;

   R⁵OR⁶; or

   R⁵SR⁶;

   wherein R⁵ is an alkylene group having 2 to 6 carbons in linear, branched or cyclic form, or an aromatic group; R⁶⁻⁷ are each independently selected from the group consisting of hydrogen, alkyl groups having 1 to 6 carbons in linear, branched or cyclic form, and aromatic groups;
(c) contacting the substrate with a silyl-chalcogen selected from the group consisting of silyltelluriums and silylseleniums;
(d) contacting the substrate with a metal compound having a general formula of: MXₙ;
   wherein M is selected from the group consisting of Sb, In, Sn, Ga, Bi, Ag, Cu, Zr, Hf, Hg, Cd, Zn and noble metals; X is a nucleophilic group selected from the group consisting of OR(alkoxy), F(fluorine), Cl (chlorine), Br (bromine), NR₂(amino), CN (cyano), OCN (cyanate), SCN (thiocyanate), diketonate, carboxylic groups and mixtures thereof; and n=1 to 5; wherein when n >1, each X is individually selected from selected from the group consisting of OR(alkoxy), F(fluorine), Cl (chlorine), Br (bromine), NR₂(amino), CN (cyano), OCN (cyanate), SCN (thiocyanate), diketonate, and carboxylic groups;
(e) optionally, purging the ALD reactor with inert gas selected from the group consisting of N₂, Ar and mixtures thereof;
   wherein the purging step (e) is performed before the contacting step (a) and after each contacting step; and
(f) all steps are repeated to achieve a desired thickness of the film.

According to yet another aspect, the present invention provides a CVD process of making a metal chalcogenide alloy film on a substrate in an CVD reactor comprising steps of:
(a) contacting the substrate with a silyl-chalcogen selected from the group consisting of silyltelluriums and silylseleniums;
(b) contacting the substrate with a germanium compound having a general formula selected from the group consisting of Ge(OR)₂, Ge(NR₂)₂ and combinations thereof;
   wherein each R is independently selected from the group consisiting of an alkyl group having 1 to 10 carbons in linear, branched or cyclic form, or an aromatic group; and
   a functionalized alkyl group with the general structure of:

   R⁵NR⁶R⁷;

   R⁵OR⁶;

   or

   R⁵SR⁶;

   wherein R⁵ is an alkylene group having 2 to 6 carbons in linear, branched or cyclic form, or an aromatic group; R⁶⁻⁷ are each independently selected from the group consisting of hydrogen, alkyl groups having 1 to 6 carbons in linear, branched or cyclic form, and aromatic groups;
(c) contacting the substrate with a metal compound having a general formula of: MXₙ;
   wherein M is selected from the group consisting of Sb, In, Sn, Ga, Bi, Ag, Cu, Zr, Hf, Hg, Cd, Zn and noble metals; X is a nucleophilic group selected from the group consisting of OR(alkoxy), F(fluorine), Cl (chlorine), Br (bromine), NR₂(amino), CN (cyano), OCN (cyanate), SCN (thiocyanate), diketonate, carboxylic groups and mixtures thereof; and n=1 to 5; wherein when n >1, each X is individually selected from selected from the group consisting of OR(alkoxy), F(fluorine), Cl (chlorine), Br (bromine), NR₂(amino), CN (cyano), OCN (cyanate), SCN (thiocyanate), diketonate, and carboxylic groups;
(d) purging the CVD reactor with inert gas selected from the group consisting of N₂, Ar and mixtures thereof; and
(e) pumping the CVD reactor down to a pressure of less than 1Torr (130 Pa);
   wherein the contacting steps (a) to (c) may be carried out sequentially or concurrently and wherein the purging and pumping steps (d) and (e) are performed before the first contacting step.

Aspects of the present invention invention include the following aspects numbered #1 to #20:
#1. A process of making a metal chalcogenide alloy film on a substrate comprising steps of:
   (a)contacting the substrate with a silyl-chalcogen selected from the group consisting of silyltellurium and silylselenium;
   (b) contacting the substrate with a germanium compound having a general formula selected from the group consisting of Ge(OR)₂ , Ge(NR₂)₂ and combinations thereof;
      wherein R is selected from the group consisiting of
      an alkyl group with 1 to 10 carbons in chain, branched, cyclic, or aromatic group; a functionalized alkyl group with the general structure of:

      R⁵NR⁶R⁷;

      R⁵OR⁶;

      and

      R⁵SR⁶;

      wherein R⁵ is an alkylene group with 2 to 6 carbons in chain, branched, cyclic, aromatic groups; R⁶⁻⁷ are independently selected from the group consisting of hydrogen, alkyl groups with 1 to 6 carbons in chain, branched, cyclic, aromatic groups;
      and
   (c) contacting the substrate with a metal compound having a general formula of:

      MXₙ;

      wherein: M is selected from the group consisting of Sb, In, Sn, Ga, Bi, Ag, Cu, Zr, Hf, Hg, Cd, Zn and noble metals;
      X is a neucleophilic group selected from the group consisting of OR(alkoxy), F(fluorine), Cl (chlorine), Br (bromine), NR₂(amino), CN (cyano), OCN (cyanate), SCN (thiocyanate), diketonate, carboxylic groups and mixtures thereof; and
      n=1 to 5; wherein when n >1, each X is individually selected from selected from the group consisting of OR(alkoxy), F(fluorine), Cl (chlorine), Br (bromine), NR₂(amino), CN (cyano), OCN (cyanate), SCN (thiocyanate), diketonate, and carboxylic groups.
#2. The process of Aspect #1 wherein the silyltellurium is selected from the group consisting of disilyltellurium having a general formula:

   (R¹R²R³Si)₂Te,

   alkylsilyltellurium having a general formula:

   (R¹R²R³Si)TeR⁴,

   and mixtures thereof; wherein R¹, R², R³, and R⁴ are independently hydrogen, alkyl groups having 1 - 10 carbons in linear, branched, or cyclic forms without or with double bonds, or aromatic groups; and
the silylselenium is selected from the group consisting of disilylselenium having a general formula: (R¹R²R³Si)₂Se, alkylsilylselenium having a general formula:

   (R¹R²R³Si)SeR⁴, and mixtures thereof;

   wherein R¹, R², R³, and R⁴, are independently hydrogen, alkyl groups having 1 - 10 carbons in linear, branched, or cyclic forms without or with double bonds, or aromatic groups.
#3. The process of Aspect #2 wherein
   the silyltellurium is selected from the group consisting of bis(trimethylsilyl)tellurium, bis(dimethylsilyl)tellurium, bis(triethylsilyl)tellurium, bis(diethylsilyl)tellurium, bis(phenyldimethylsilyl)tellurium, bis(t-butyldimethylsilyl)tellurium, dimethylsilylmethyltellurium, dimethylsilylphenyltellurium, dimethylsilyl-n-butyltellurium, dimethylsilyl-t-butyltellurium, trimethylsilylmethyltellurium, trimethylsilylphenyltellurium, trimethylsilyl-n-butyltellurium, and trimethylsilyl-t-butyltellurium; and
   the silylselenium is selected from the group consisting of bis(trimethylsilyl)selenium, bis(dimethylsilyl)selenium, bis(triethylsilyl)selenium, bis(diethylsilyl) selenium, bis(phenyldimethylsilyl) selenium, bis(t-butyldimethylsilyl) selenium, dimethylsilylmethyl selenium, dimethylsilylphenyl selenium, dimethylsilyl-n-butyl selenium, dimethylsilyl-t-butyl selenium, trimethylsilylmethyl selenium, trimethylsilylphenyl selenium, trimethylsilyl-n-butyl selenium, and trimethylsilyl-t-butylselenium.
#4. The process of Aspect #1, wherein the germanium compound is selected from the group consisting of Ge(OBu^{t})₂, Ge(OCH₂CH₂NMe₂)₂, Ge(OCH(Me)CH₂CH₂NMe₂)₂, Ge(OC(Me)₂CH₂CH₂NMe₂)₂, Ge(OCH(Me) CH₂CH₂NEt₂)₂Ge, (OCMe₂CH₂CH₂NEt₂)₂, Ge(OCH₂CH₂OMe)₂, Ge(OCH₂CH₂OEt)₂, Ge(OCH₂CH₂OPrⁱ)₂,, Ge(OCH(Me)CH₂CH₂OMe)₂, Ge(OCH(Me)CH₂CH₂OEt)₂, Ge(OCH(Me)CH₂CH₂OPrⁱ)₂, Ge(OC(Me)₂CH₂CH₂OMe)₂, Ge(OC(Me)₂CH₂CH₂OEt)₂, Ge(OC(Me)₂CH₂CH₂OPrⁱ)₂, Ge(OCH₂CH₂SMe)₂, Ge(MeNCH₂CH₂NMe₂)₂, Ge(MeNCH₂CH₂NEt₂)₂.
#5. The process of Aspect #1, wherein the metal compound is an antimony compound selected from the group consisting of (a) (RO)₃Sb, where R is an alkyl group with 1 to 10 carbons in chain, branched, or cyclic; (b) (R¹ R²N)₃Sb, where R¹ and R² are individually alkyl groups with 1 to 10 carbons in chain, branched, or cyclic; and (c) antomony halide with the general formula: SbX₃ and SbX₅, where X is F, Cl, or Br.
#6. The process of Aspect #5, the antimony compound is selected from the group consisting of Sb(OMe)₃, Sb(OEt)₃, Sb(NMe₂)₃, Sb(NMeEt)₃, and Sb(NEt₂)₂.
#7. The process of Aspect #1 wherein the process is selected from the group consisting of atomic layer deposition (ALD) process, Chemical Vapor Deposition (CVD) process and solution wet chemistry.
#8. The process of Aspect #1, wherein the metal chalcogenide alloy film is germanium-antimony-tellurium with a composition of Ge₂Sb₂Te₅.
#9. An ALD process of making a metal chalcogenide alloy film on a substrate in an ALD reactor comprising steps of:
   (a)contacting the substrate with a silyl-chalcogen selected from the group consisting of silyltellurium and silylselenium; and
   (b) contacting the substrate with a germanium compound having a general formula selected from the group consisting of Ge(OR)₂ , Ge(NR₂)₂ and combinations thereof;
      wherein R is selected from the group consisiting of
      an alkyl group with 1 to 10 carbons in chain, branched, cyclic, or aromatic group; a functionalized alkyl group with the general structure of:

      R⁵NR⁶R⁷;

      R⁵OR⁶;

      and

      R⁵SR⁶;

      wherein R⁵ is an alkylene group with 2 to 6 carbons in chain, branched, cyclic, aromatic groups; R⁶⁻⁷ are independently selected from the group consisting of hydrogen, alkyl groups with 1 to 6 carbons in chain, branched, cyclic, aromatic groups;
   (c) contacting the substrate with a silyl-chalcogen selected from the group consisting of silyltellurium and silylselenium;
   (d) contacting the substrate with a metal compound having a general formula of: MXₙ;
      wherein M is selected from the group consisting of Sb, In, Sn, Ga, Bi, Ag, Cu, Zr, Hf, Hg, Cd, Zn and noble metals; X is a neucleophilic group selected from the group consisting of OR(alkoxy), F(fluorine), Cl (chlorine), Br (bromine), NR₂(amino), CN (cyano), OCN (cyanate), SCN (thiocyanate), diketonate, carboxylic groups and mixtures thereof; and n=1 to 5; wherein when n >1, each X is individually selected from selected from the group consisting of OR(alkoxy), F(fluorine), Cl (chlorine), Br (bromine), NR₂(amino), CN (cyano), OCN (cyanate), SCN (thiocyanate), diketonate, and carboxylic groups;
   (e)optionally, purging the ALD reactor with inert gas selected from the group consisting of N₂, Ar and mixtures thereof;
      wherein the purging step (e) is performed before the contacting step (a) and
      after each contacting step; and
   (f)all steps are repeated to achieve a desired thickness of the film.
#10. The ALD process of Aspect # 9, wherein
   the silyltellurium is selected from the group consisting of disilyltellutium having a general formula: (R¹R²R³Si)₂Te, alkylsilyltellurium having a general formula: (R¹R²R³Si)TeR⁴ , and mixtures thereof;
   wherein R¹, R², R³, and R⁴, are independently hydrogen, alkyl groups having 1 - 10 carbons in linear, branched, or cyclic forms without or with double bonds, or aromatic groups; and
   the silylselenium is selected from the group consisting of
   disilylselenium having a general formula: (R¹R²R³Si)₂Se,
   alkylsilylselenium having a general formula: (R¹R²R³Si)SeR⁴ , and mixtures thereof;
   wherein R¹, R², R³, and R⁴, are independently hydrogen, alkyl groups having 1 - 10 carbons in linear, branched, or cyclic forms without or with double bonds, or aromatic groups; and
   the metal compound is an antimony compound selected from the group consisting of (a) (RO)₃Sb, where R is an alkyl group with 1 to 10 carbons in chain, branched, or cyclic; (b) (R¹ R²N)₃Sb, where R¹ and R² are individually alkyl groups with 1 to 10 carbons in chain, branched, or cyclic; and (c) antomony halide with the general
   formula: SbX₃ and SbX₅, where X is F, Cl, or Br.
#11. The ALD process of Aspect #10, wherein
   the silyltellurium is selected from the group consisting of bis(trimethylsilyl)tellurium, bis(dimethylsilyl)tellurium, bis(triethylsilyl)tellurium, bis(diethylsilyl)tellurium, bis(phenyldimethylsilyl)tellurium, bis(t-butyldimethylsilyl)tellurium, dimethylsilylmethyltellurium, dimethylsilylphenyltellurium, dimethylsilyl-n-butyltellurium, dimethylsilyl-t-butyltellurium, trimethylsilylmethyltellurium, trimethylsilylphenyltellurium, trimethylsilyl-n-butyltellurium, and trimethylsilyl-t-butyltellurium; and
   the silylselenium is selected from the group consisting of bis(trimethylsilyl)selenium, bis(dimethylsilyl)selenium, bis(triethylsilyl)selenium, bis(diethylsilyl) selenium, bis(phenyldimethylsilyl) selenium, bis(t-butyldimethylsilyl) selenium, dimethylsilylmethyl selenium, dimethylsilylphenyl selenium, dimethylsilyl-n-butyl selenium, dimethylsilyl-t-butyl selenium, trimethylsilylmethyl selenium, trimethylsilylphenyl selenium, trimethylsilyl-n-butyl selenium, and trimethylsilyl-t-butylselenium.
#12. The ALD process of Aspect #10, wherein the germanium compound is selected from the group consisting of Ge(OBu^{t})₂, Ge(OCH₂CH₂NMe₂)₂, Ge(OCH(Me)CH₂CH₂NMe₂)₂, Ge(OC(Me)₂CH₂CH₂NMe₂)₂, Ge(OCH(Me) CH₂CH₂NEt₂)₂Ge, (OCMe₂CH₂CH₂NEt₂)₂, Ge(OCH₂CH₂OMe)₂, Ge(OCH₂CH₂OEt)₂, Ge(OCH₂CH₂OPrⁱ)₂,, Ge(OCH(Me)CH₂CH₂OMe)₂, Ge(OCH(Me)CH₂CH₂OEt)₂, Ge(OCH(Me)CH₂CH₂OPrⁱ)₂, Ge(OC(Me)₂CH₂CH₂OMe)₂, Ge(OC(Me)₂CH₂CH₂OEt)₂, Ge(OC(Me)₂CH₂CH₂OPrⁱ)₂, Ge(OCH₂CH₂SMe)₂, Ge(MeNCH₂CH₂NMe₂)₂, Ge(MeNCH₂CH₂NEt₂)₂; and
   the antimony compound is selected from the group consisting of Sb(OMe)₃, Sb(OEt)₃, Sb(NMe₂)₃, Sb(NMeEt)₃, and Sb(NEt₂)₂.
#13. The ALD process of Aspect #11, wherein the germanium compound is selected from the group consisting of Ge(OBu^{t})₂, Ge(OCH₂CH₂NMe₂)₂, Ge(OCH(Me)CH₂CH₂NMe₂)₂, Ge(OC(Me)₂CH₂CH₂NMe₂)₂, Ge(OCH(Me) CH₂CH₂NEt₂)₂Ge, (OCMe₂CH₂CH₂NEt₂)₂, Ge(OCH₂CH₂OMe)₂, Ge(OCH₂CH₂OEt)₂, Ge(OCH₂CH₂OPrⁱ)₂,, Ge(OCH(Me)CH₂CH₂OMe)₂, Ge(OCH(Me)CH₂CH₂OEt)₂, Ge(OCH(Me)CH₂CH₂OPrⁱ)₂, Ge(OC(Me)₂CH₂CH₂OMe)₂, Ge(OC(Me)₂CH₂CH₂OEt)₂, Ge(OC(Me)₂CH₂CH₂OPrⁱ)₂, Ge(OCH₂CH₂SMe)₂, Ge(MeNCH₂CH₂NMe₂)₂, Ge(MeNCH₂CH₂NEt₂)₂; and
   the antimony compound is selected from the group consisting of Sb(OMe)₃, Sb(OEt)₃, Sb(NMe₂)₃, Sb(NMeEt)₃, and Sb(NEt₂)₂.
#14. The ALD process of Aspect #13, wherein the metal chalcogenide alloy film is germanium-antimony-tellurium with a composition of Ge₂Sb₂Te₅.
#15. A CVD process of making a metal chalcogenide alloy film on a substrate in an CVD reactor comprising steps of:
   (a) contacting the substrate with a silyl-chalcogen selected from the group consisting of silyltellurium and silylselenium;
   (b) contacting the substrate with a germanium compound having a general formula selected from the group consisting of Ge(OR)₂ , Ge(NR₂)₂ and combinations thereof;
      wherein R is selected from the group consisiting of
      an alkyl group with 1 to 10 carbons in chain, branched, cyclic, or aromatic group; a functionalized alkyl group with the general structure of:

      R⁵NR⁶R⁷;

      R⁵OR⁶;

      and

      R⁵SR⁶;

      wherein R⁵ is an alkylene group with 2 to 6 carbons in chain, branched, cyclic, aromatic groups; R⁶⁻⁷ are independently selected from the group consisting of hydrogen, alkyl groups with 1 to 6 carbons in chain, branched, cyclic, aromatic groups;
   (c)contacting the substrate with a metal compound having a general formula of: MXₙ;
      wherein M is selected from the group consisting of Sb, In, Sn, Ga, Bi, Ag, Cu, Zr, Hf, Hg, Cd, Zn and noble metals; X is a neucleophilic group selected from the group consisting of OR(alkoxy), F(fluorine), Cl (chlorine), Br (bromine), NR₂(amino), CN (cyano), OCN (cyanate), SCN (thiocyanate), diketonate, carboxylic groups and mixtures thereof; and n=1 to 5; wherein when n >1, each X is individually selected from selected from the group consisting of OR(alkoxy), F(fluorine), Cl (chlorine), Br (bromine), NR₂(amino), CN (cyano), OCN (cyanate), SCN (thiocyanate), diketonate, and carboxylic groups;
   (d)purging the CVD reactor with inert gas selected from the group consisting of N₂, Ar and mixtures thereof; and
   (e)pumping the CVD reactor down to a pressure of less than 1 Torr;
   wherein the purging and pumping steps (d) and (e) are performed before the contacting step (a).
#16. The CVD process of Aspect #15, wherein the contacting steps are carried out sequentially or concurrently.
#17. The CVD process of Aspect #15, wherein the silyltellurium is selected from the group consisting of bis(trimethylsilyl)tellurium, bis(dimethylsilyl)tellurium, bis(triethylsilyl)tellurium, bis(diethylsilyl)tellurium, bis(phenyldimethylsilyl)tellurium, bis(t-butyldimethylsilyl)tellurium, dimethylsilylmethyltellurium, dimethylsilylphenyltellurium, dimethylsilyl-n-butyltellurium, dimethylsilyl-t-butyltellurium, trimethylsilylmethyltellurium, trimethylsilylphenyltellurium, trimethylsilyl-n-butyltellurium, and trimethylsilyl-t-butyltellurium; and
   the silylselenium is selected from the group consisting of bis(trimethylsilyl)selenium, bis(dimethylsilyl)selenium, bis(triethylsilyl)selenium, bis(diethylsilyl) selenium, bis(phenyldimethylsilyl) selenium, bis(t-butyldimethylsilyl) selenium, dimethylsilylmethyl selenium, dimethylsilylphenyl selenium, dimethylsilyl-n-butyl selenium, dimethylsilyl-t-butyl selenium, trimethylsilylmethyl selenium, trimethylsilylphenyl selenium, trimethylsilyl-n-butyl selenium, and trimethylsilyl-t-butylselenium.
#18. The CVD process of Aspect #15, wherein the germanium compound is selected from the group consisting of Ge(OBu^{t})₂, Ge(OCH₂CH₂NMe₂)₂, Ge(OCH(Me)CH₂CH₂NMe₂)₂, Ge(OC(Me)₂CH₂CH₂NMe₂)₂, Ge(OCH(Me) CH₂CH₂NEt₂)₂Ge, (OCMe₂CH₂CH₂NEt₂)₂, Ge(OCH₂CH₂OMe)₂, Ge(OCH₂CH₂OEt)₂, Ge(OCH₂CH₂OPrⁱ)₂,, Ge(OCH(Me)CH₂CH₂OMe)₂, Ge(OCH(Me)CH₂CH₂OEt)₂, Ge(OCH(Me)CH₂CH₂OPrⁱ)₂, Ge(OC(Me)₂CH₂CH₂OMe)₂, Ge(OC(Me)₂CH₂CH₂OEt)₂, Ge(OC(Me)₂CH₂CH₂OPrⁱ)₂, Ge(OCH₂CH₂SMe)₂, Ge(MeNCH₂CH₂NMe₂)₂, Ge(MeNCH₂CH₂NEt₂)₂; and
   the antimony compound is selected from the group consisting of Sb(OMe)₃, Sb(OEt)₃, Sb(NMe₂)₃, Sb(NMeEt)₃, and Sb(NEt₂)₂.
#19. The CVD process of Aspect #17, wherein the germanium compound is selected from the group consisting of Ge(OBu^{t})₂, Ge(OCH₂CH₂NMe₂)₂, Ge(OCH(Me)CH₂CH₂NMe₂)₂, Ge(OC(Me)₂CH₂CH₂NMe₂)₂, Ge(OCH(Me) CH₂CH₂NEt₂)₂Ge, (OCMe₂CH₂CH₂NEt₂)₂, Ge(OCH₂CH₂OMe)₂, Ge(OCH₂CH₂OEt)₂, Ge(OCH₂CH₂OPrⁱ)₂,, Ge(OCH(Me)CH₂CH₂OMe)₂, Ge(OCH(Me)CH₂CH₂OEt)₂, Ge(OCH(Me)CH₂CH₂OPrⁱ)₂, Ge(OC(Me)₂CH₂CH₂OMe)₂, Ge(OC(Me)₂CH₂CH₂OEt)₂, Ge(OC(Me)₂CH₂CH₂OPrⁱ)₂, Ge(OCH₂CH₂SMe)₂, Ge(MeNCH₂CH₂NMe₂)₂, Ge(MeNCH₂CH₂NEt₂)₂; and
   the antimony compound is selected from the group consisting of Sb(OMe)₃, Sb(OEt)₃, Sb(NMe₂)₃, Sb(NMeEt)₃, and Sb(NEt₂)₂.
#20. The CVD process of Aspect #19, wherein the metal chalcogenide alloy film is germanium-antimony-tellurium with a composition of Ge₂Sb₂Te₅.

### BRIEF DESCRIPTION OF SEVERAL VIEWS OF THE DRAWINGS

Figure 1. Thermo-gravimetric analysis (TGA) and differential scanning calorimetry (DSC) of bis(trimethylsilyl)tellurium.
Figure 2. Scanning Electron Microscopy (SEM) picture of GeTe sample.
Figure 3. Energy Dispersive X-ray Analysis (EDX) of GeTe sample.
Figure 4. Scanning Electron Microscopy (SEM) picture of SbTe sample.
Figure 5. Energy Dispersive X-ray Analysis (EDX) of SbTe sample.
Figure 6. Scanning Electron Microscopy (SEM) picture of GeSbTe sample.
Figure 7. Energy Dispersive X-ray Analysis (EDX) of GeSbTe ternary film.
Figure 8. Energy Dispersive X-ray Analysis (EDX) of an Atomic Layer Deposition (ALD) GeTe film.
Figure 9. Energy Dispersive X-ray Analysis (EDX) of an Atomic Layer Deposition (ALD) SbTe film.
Figure 10. Energy Dispersive X-ray Analysis (EDX) of an Atomic Layer Deposition (ALD) GeSbTe film.

### DETAILED DESCRIPTION OF THE INVENTION

Binary, ternary, and quaternary metal chalcogenides have been used as phase change and photovoltaic materials.

Ligand exchange reactions of silyl-chalcogens, such as organosilyltellurium or silyltellurium, organosilylselenium or silylselenium with a series of metal compounds having nucleophilic substituents generate metal chalcogenides in solution or gas phase. Binary, ternary, and multi-element metal tellurides and selenides are prepared using these methods.

Chemical vapor deposition (CVD) is a well-established chemical process for depositing thin films of various materials in the semiconductor industry, as part of the semiconductor device fabrication process. The CVD process may include but is not limited to metal organic chemical vapor deposition (MOCVD), cyclic chemical vapor deposition (cyclic-CVD), Direct liquid injection CVD (DLICVD), Low-pressure CVD (LPCVD), Microwave-Enhanced CVD, and Plasma-Enhanced CVD (PECVD).

In a typical CVD process the substrate is exposed to one or more volatile precursors , which react and/or decompose on the substrate surface to produce the desired deposit. Frequently, precursors with vapor pressures insufficient for vapor draw are introduced to the reaction chamber via direct liquid injection (DLI).

CVD offers many advantages, including:
Versatile - can deposit any element or compound;
High Purity - typically 99.99-99.999%;
High Density - nearly 100% of theoretical;
Material Formation well below the melting point;
Coatings Deposited by CVD are conformal and near net shape;
Economical in production, since many parts can be coated at the same time.

Atomic Layer Deposition (ALD) is a unique modification of the chemical vapor deposition method for highly controlled deposition of thin films. It is a self-limiting (the amount of film material deposited in each reaction cycle is constant), sequential process (the precursor vapors are brought onto the substrates alternately, one at a time, separated by purging periods with inert gas). ALD is considered as one of the deposition methods with the greatest potential for producing very thin, conformal films with control of the thickness and composition of the films being possible at the atomic level. A major driving force for the recent interest is the prospects seen for ALD in scaling down microelectronic devices.

Using ALD, Film thickness depends only on the number of reaction cycles, which makes the thickness control accurate and simple. Unlike CVD, there is less need of reactant flux homogeneity, which gives large area (large batch and easy scale-up) capability, excellent conformality and reproducibility, and simplifies the use of solid precursors. Also, the growth of different multilayer structures is straight forward. These advantages make the ALD method attractive for microelectronics for manufacturing of future generation integrated circuits. Another advantage of ALD is the wide range of film materials available, and high density and low impurity level. Also, lower deposition temperature can be used in order not to affect sensitive substrates.

The present invention provides silyl-chalcogens, such as silyltellurium and silylselenium compounds as precursors for tellurium and selenium sources, which react with metal compounds having nucleophilic substituents to form metal tellurides and metal selenides. Ternary and quaternary telluride and selenide compounds can be made by adding metal compounds in a sequential manner or in a mixed manner, in a CVD or an ALD process. The material and the technologies disclosed in the present invention will be applied to the deposition of GST films or other metal chalcogenide compounds for phase change memory applications, and various thin films in photovoltaic devices.

Tellurium precursors can contain disilyltellurium, silylalkyltellurium, with the general structures of:

(R¹R²R³Si)₂Te,

(R¹R²R³Si)R⁴Te ;

and Selenium precursors can contain disilylselenium, silylalkylselenium, with the general structures of:

(R¹R²R³Si)₂Se,

(R¹R²R³Si)R⁴Se ;

where R¹, R², R³, and R⁴, are independently hydrogen, alkyl groups having 1 - 10 carbons in linear, branched, or cyclic forms without or with double bonds, or aromatic groups.

Examples for the silyltellurium precursor are including but not limited to bis(trimethylsilyl)tellurium, bis(dimethylsilyl)tellurium, bis(triethylsilyl)tellurium, bis(diethylsilyl)tellurium, bis(phenyldimethylsilyl)tellurium, bis(t-butyldimethylsilyl)tellurium, dimethylsilylmethyltellurium, dimethylsilylphenyltellurium, dimethylsilyl-n-butyltellurium, dimethylsilyl-t-butyltellurium, trimethylsilylmethyltellurium, trimethylsilylphenyltellurium, trimethylsilyl-n-butyltellurium, and trimethylsilyl-t-butyltellurium.

Examples for the silylselenium precursor are including but not limited to bis(trimethylsilyl)selenium, bis(dimethylsilyl)selenium, bis(triethylsilyl)selenium, bis(diethylsilyl) selenium, bis(phenyldimethylsilyl) selenium, bis(t-butyldimethylsilyl) selenium, dimethylsilylmethyl selenium, dimethylsilylphenyl selenium, dimethylsilyl-n-butyl selenium, dimethylsilyl-t-butyl selenium, trimethylsilylmethyl selenium, trimethylsilylphenyl selenium, trimethylsilyl-n-butyl selenium, and trimethylsilyl-t-butylselenium.

Metal compounds have the general formula of:

MXₙ

where M is the metal selected from the periodic table of elements, including but not limited to: Ge, Sb, In, Sn, Ga, Bi, Ag, Cu, Zr, Hf, Hg, Cd, Zn and noble metals; and X is nucleophilic group such as OR(alkoxy), F(fluorine), Cl (chlorine), Br (bromine), NR₂(amino), CN (cyano), OCN (cyanate), SCN (thiocyanate), diketonate, or carboxylic groups. n=1 to 5; wherein when n >1, each X is individually selected from selected from the group consisting of OR(alkoxy), F(fluorine), Cl (chlorine), Br (bromine), NR₂(amino), CN (cyano), OCN (cyanate), SCN (thiocyanate), diketonate, and carboxylic groups.

Examples of Ge compounds include but are not limited to:
(1) (R¹O)₄Ge or (R¹O)ₙGeH₄₋ₙ where R¹ is an alkyl group with 1 to 10 carbons in linear, branched, or cyclic form, or an aromatic group; and n=1 to 3;
(2) (R¹ R²N)₄Ge or (R¹ R²N)₄₋ₙGeHₙ, where R¹ and R² are individually alkyl groups with 1 to 10 carbons in linear, branched, or cyclic form, or aromatic groups; and n= 1 to 3;
(3) GeX₄, GeX₂, or RₙGeX₄₋ₙ, where X is F, Cl, or Br, R is hydrogen, or alkyl groups with 1 to 10 carbons in linear, branched, or cyclic form or aromatic groups; and n = 0-3.
(4) Ge(OR)₂ where R is an alkyl group with 1 to 10 carbons in linear, branched, or cyclic form, or an aromatic group. Examples include but are not limited to:
   Ge(OBu^{t})₂ (bis(tert-butoxy)germanium)
(5) Ge(OR)₂ where R =R⁵NR⁶R⁷ wherein R⁵ is an alkylene group with 1 to 6 carbons in linear, branched, or cyclic form, or an aromatic group; and R⁶⁻⁷ are each independently selected from the group consisting of hydrogen, alkyl groups with 1 to 6 carbons in linear, branched, or cyclic form, and aromatic groups. R⁶ and R⁷ can be linked to form a ring. R⁵ and R⁶ can also be linked to form a ring. Examples include but are not limited to: Ge(OCH₂CH₂NMe₂)₂, Ge(OCH(Me)CH₂CH₂NMe₂)₂, Ge(OC(Me)₂CH₂CH₂NMe₂)₂, Ge(OCH(Me)CH₂CH₂NEt₂)₂, Ge(OC(Me)₂CH₂CH₂NEt₂)₂;
(6) Ge(OR)₂ where R =R⁵OR⁶ wherein R⁵ is an alkylene group with 1 to 6 carbons in linear, branched, or cyclic form, or an aromatic group; and R⁶ is hydrogen, an alkyl group with 1 to 6 carbons in linear, branched, or cyclic form, or an aromatic group. Examples include but are not limited to: Ge(OCH₂CH₂OMe)₂, Ge(OCH₂CH₂OEt)₂, Ge(OCH₂CH₂OPrⁱ)₂, Ge(OCH(Me)CH₂cH₂OMe)₂, Ge(OCH(Me)CH₂CH₂OEt)₂, Ge(OCH(Me)CH₂CH₂OPrⁱ)₂, Ge(OC(Me)₂CH₂CH₂OMe)₂, Ge(OC(Me)₂CH₂CH₂OEt)₂, Ge(OC(Me)₂CH₂CH₂OPrⁱ)₂;
(7) Ge(OR)₂ where R =R⁵SR⁶ wherein R⁵ is an alkylene group with 1 to 6 carbons in linear, branched, or cyclic form, or an aromatic group; and R⁶ is hydrogen, an alkyl group with 1 to 6 carbons in linear, branched, or cyclic form, or an aromatic group. Examples include but are not limited to: Ge(OCH₂CH₂SMe)₂; and
(8) Ge(NR₂)₂ where the two Rs can be independently selected from the group consisting of alkyl groups with 1 to 6 carbons in linear, branched, or cyclic form, aromatic groups, and functionalized alkyl groups of the general formula R⁵NR⁶R⁷ wherein R⁵ is an alkylene group with 1 to 6 carbons in linear, branched, or cyclic form, or an aromatic group, and R⁶⁻⁷ are each independently selected from the group consisting of hydrogen, alkyl groups with 1 to 6 carbons in linear, branched, or cyclic form, and aromatic groups. R⁶ and R⁷ can be linked to form a ring. R⁵ and R⁶ can also be linked to form a ring. Examples include but are not limited to: Ge(MeNCH₂CH₂NMe₂)₂, Ge(MeNCH₂CH₂NEt₂)₂;

Examples of Sb compounds include but are not limited to:
(1) (RO)₃Sb, where R is an alkyl group with 1 to 10 carbons in linear, branched, or cyclic form. Examples include but are not limited to Sb(OMe)₃, Sb(OEt)₃;
(2) (R¹ R²N)₃Sb, where R¹ and R² are individually alkyl groups with 1 to 10 carbons in linear, branched, or cyclic form. Examples include but are not limited to Sb(NMe₂)₃, Sb(NMeEt)₃, and Sb(NEt₂)₂;
(3) antomony halide with the general formula: SbX₃ or SbX₅, where X is F, Cl, or Br;
   and
(4) (RO)ₓSb(NR¹R²)₃₋ₓ, where R and R¹⁻² are individually selected from the group consisting of alkyl groups with 1 to 10 carbons in linear, branched, or cyclic form.

Silicon - tellurium bonds and silicon - selenium bonds are highly reactive toward nucleophilic attack due to their high degree of ionic character and low bond energy. When reacted with the metal compound, MXₙ, the silyl groups tend to combine with the electronegative ligands X forming stronger bonds, resulting the formation of metal - tellurium bonds and metal - selenium bonds. Studies shows the chemical bond reactivity on silicon has the following order as shown in equation (1). The bond with high reactivity can be readily converted to the one with low reactivity.

The chemical bond reactivity from high activity to low activity is shown below:

**Si-Te > Si-I > Si-Se > Si- S > Si-Br > Si-CI > Si-CN > Si-NCS > Si-O > Si-F** **(1)**

The formation of metal telluride can be demonstrated by the following examplary reactions

Me₃Si-Te-SiMe₃ + M(OR)n -------> MTe + Me₃SiOR

Me₃Si-Te-SiMe₃ + M(F)n-------> MTe + Me₃SiF

Me₃Si-Te-SiMe₃ + M(NR₂)n -------> MTe + Me₃SiNR₂

The formation of metal selenides can be demonstrated in the similar reactions.

In particular, GST materials suitable for phase change memory devices can be generated by reactions shown below in CVD or ALD reactors

Me₃Si-Te-SiMe₃ + Ge(OMe)₄ + Sb(OEt)₃ ---------> GeSbTe + Me₃SiOEt + Me₃SiOMe

Me₃Si-Te-SiMe₃ + GeF₄ + SbF₅ ---------> GeSbTe + Me₃SiF

Me₃Si-Te-SiMe₃ + Ge(NMe₂)₄ + Sb(NMe₂)₃---------> GeSbTe + Me₃SiNMe₂

where GeSbTe represents a general formula of germanium-antimony telluride compounds, wherein the ratio of three elements may differ.

In a specific embodiment to form Ge₂Sb₂Te₅ materials suitable for phase change memory devices can be generated by reactions shown below in CVD or ALD reactors

5Me₃Si-Te-SiMe₃ + 2Ge(OBU^{t})₂ + 2Sb(OEt)₃ ---------> Ge₂Sb₂Te₅ + 6Me₃SiOEt + 4Me₃SiOBu^{t}

5Me₃Si-Te-SiMe₃ + 2Ge(OCH₂CH₂NMe₂)₂ + 2Sb(OEt)₃---------> Ge₂Sb₂Te₅ + 6Me₃SiOEt + 4Me₃Si OCH₂CH₂NMe₂

5Me₃Si-Te-SiMe₃ + 2Ge(OCH₂CH₂OMe)₂ + 2Sb(OEt)₃---------> Ge₂Sb₂Te₅ + 6Me₃SiOEt + 4Me₃Si OCH₂CH₂OMe

5Me₃Si-Te-SiMe₃ + 2Ge(OCH₂CH₂SMe)₂ + 2Sb(OEt)₃---------> Ge₂Sb₂Te₅ + 6Me₃SiOEt + 4Me₃Si OCH₂CH₂SMe

5Me₃Si-Te-SiMe₃ + 2Ge(OBu^{t})₂ + 2Sb(NMe₂)₃ ---------> Ge₂Sb₂Te₅ + 6Me₃SiNMe₂ + 4Me₃SiOBu^{t}

5Me₃Si-Te-SiMe₃ + 2Ge(OCH₂CH₂NMe₂)₂ + 2Sb(NMe₂)₃ ---------> Ge₂Sb₂Te₅ + 6Me₃SiNMe₂ + 4Me₃SiOCH₂CH₂NMe₂

5Me₃Si-Te-SiMe₃ + 2Ge(OCH₂CH₂OMe)₂ + 2Sb(NMe₂)₃---------> Ge₂Sb₂Te₅ + 6Me₃SiNMe₂ + 4Me₃SiOCH₂CH₂OMe

5Me₃Si-Te-SiMe₃ + 2Ge(OCH₂CH₂SMe)₂ + 2Sb(NMe₂)₃---------> Ge₂Sb₂Te₅ + 6Me₃SiNMe₂ + 4Me₃SiOCH₂CH₂SMe

ALD process of depositing GeSbTe films from silyltellurium compound and alkoxygermane and alkoxyantimony can be illustrated by the reaction scheme shown below. ALD process of depositing GeSbSe (germanium-antimony- selenium) films from silylselenium compound and alkoxygermane and alkoxyantimony can be illustrated in the similar reaction scheme.

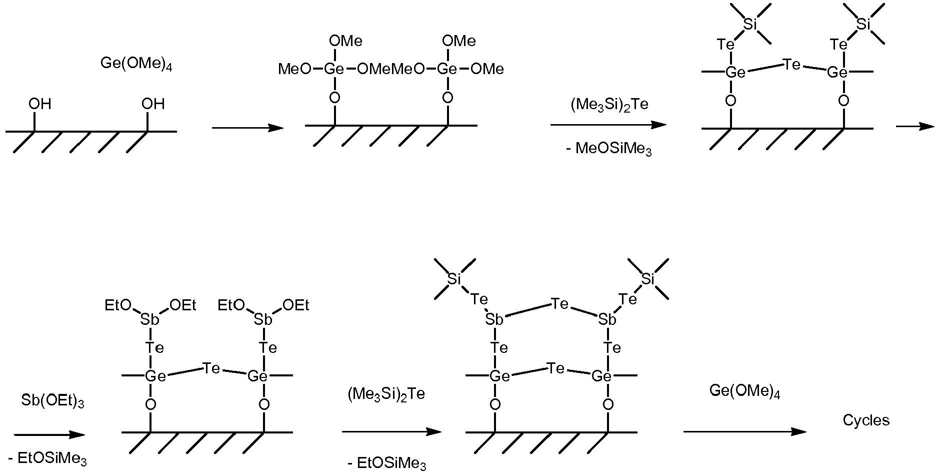

ALD is considered as a unique process used to deposit GST films or other metal chalcogenide compounds for phase change memory applications, for ALD can be applied to small dimension holes (such as the contact holes) that chemical vapor deposition (CVD) or sputtering methods cannot. The ALD process may include plasma-enhanced ALD.

In the present invention, the precursors may be provided simultaneously (e.g., CVD), sequentially (e.g., cyclic-CVD, ALD), or in any combinations during the deposition. Alternatively, the precursors may also be provided sequentially by providing a precursor and purging the unabsorbed precursor prior to providing the next precursor. Thus, a precursor that has been supplied but not absorbed may be purged.

The deposition pressure may be maintained at about 0.001-10 torr (130-1300 Pa), and the deposition temperature may be maintained at about 50-400° C. The precursors may be heated before being fed into the ALD reactor.

In the examples that follow, GeTe, SbTe, GeSbTe (GST) films were deposited by ALD. Scanning electron microscope (SEM), was used to obtain cross-sectional image and surface morphology of samples. The phase transition properties of samples and films were characterized by Energy Dispersive X-ray Analysis.

### Working Examples and Embodiments

(Only embodiments 10-13 are in accordance with the invention)

### Example 1 Synthesis of Bis(trimethylsilyl)tellurium

1.28g (0.01 mol) 200 mesh tellurium powder, 0.48 g (0.02 mol) lithium hydride, and 40 ml tetrahydrofuran (THF) were placed in a 100 ml flask. With stirring, the mixture was refluxed for 4 hours. All black powder of tellurium disappeared, and a muddy color precipitate was formed. Then, the mixture was cooled down to - 20 °C; 2.2 g (0.02 mol) trimethylchlorosilane was added. The mixture was allowed to warm up to room temperature. After stirring for 4 hours, the mixture was filtered under inert atmosphere. The solvent was removed by distillation. Bis(trimethylsilyl)tellurium was purified by vacuum distillation, b.p. 50 °C at 2.5 mm Hg (330 Pa).

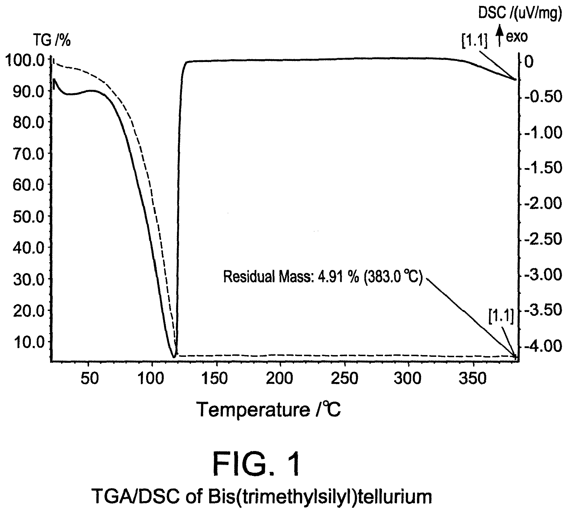

Thermo-gravimetric analysis (TGA) and differential scanning calorimetry (DSC) were used to characterize Bis(trimethylsilyl)tellurium. The results are shown in Figure 1. The compound is stable upon heating up to 120 °C. It can be conveniently stored and handled at room temperature or with mild heating.

### Example 2 Synthesis of Tetramethyldisilyltellurium

3.84 g (0.03 mol) 200 mesh tellurium powder, 1.44 g (0.06 mol) lithium hydride, and 40 ml tetrahydrofuran (THF) were placed in a 100 ml flask. With stirring, the mixture was refluxed for 4 hours. All black powder of tellurium disappeared, and a muddy color precipitate was formed. Then, the mixture was cooled down to - 20 °C; 5.77 g (0.06 mol) dimethylchlorosilane was added. The mixture was allowed to warm up to room temperature. After stirring for 4 hours, the mixture was filtered under inert atmosphere. The solvent was removed by distillation. Tetramethyldisilyltellurium was purified by vacuum distillation, Boiling Point 50 °C at 4 mm Hg (530 Pa).

### Example 3 Synthesis of Trimethylsilyl-t-butyltellurium

6.4 g (0.05 mol) 200 mesh tellurium powder, 100 ml diethyl ether, and 20 ml 2.5 M t-butyllithium in hexane were added to a 250 ml flask. At 0° C, the mixture was stirred for 8 hours. All black powder of tellurium disappeared, and a muddy color precipitate was formed. To this mixture, 5.4 g (0.05 mol) trimethylchlorosilane was added. The mixture was allowed to warm up to room temperature. After stirring for 1 hour, the mixture was filtered under inert atmosphere. The solvent was removed by distillation. Trimethylsilyl-t-butyltellurium was purified by vacuum distillation.

### Example 4 Synthesis of germanium telluride sample

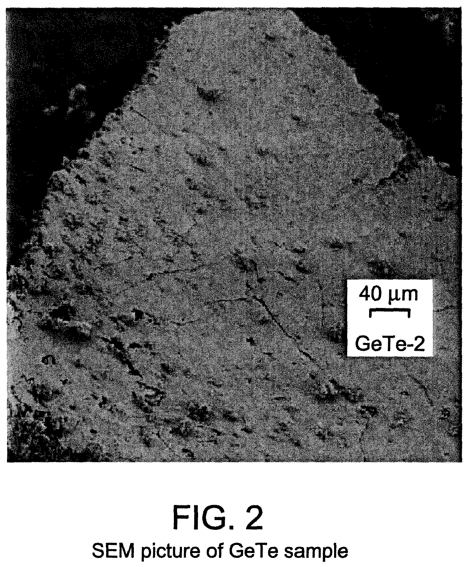

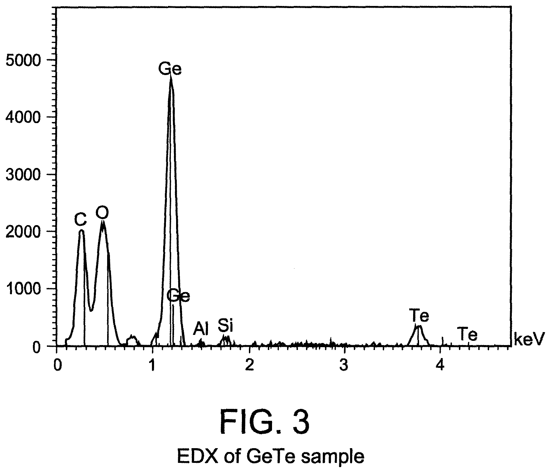

0.27 g (0.001 mol) Bis(trimethylsilyl)tellurium was dissolved in 6 ml of acetonitrile. To the solution, 0.12 g tetramethoxygermane was added at room temperature. The reaction was exo-thermic. A black precipitate was formed immediately. The precipitate was filtered out and washed with THF, and dried in air. Energy Dispersive X-ray Analysis (EDX) in conjunction with Scanning Electron Microscopy (SEM) have been used to study the black solid precipitate. The results are shown in Figures 2 and 3. The results indicated that the black solid was a composition of germanium and tellurium. Germanium telluride is insoluble in organic solvents.

### Example 5 Synthesis of antimony telluride sample

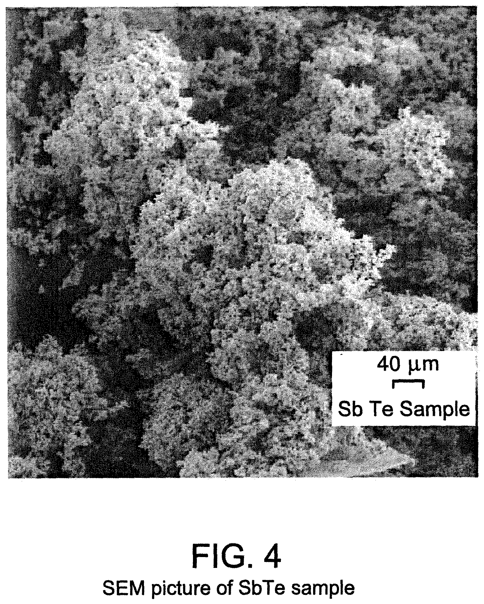

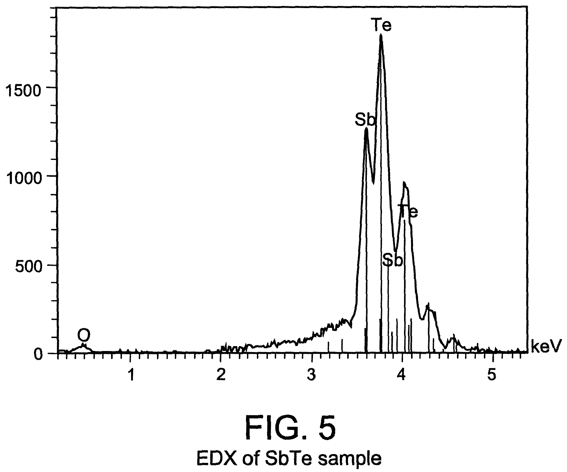

0.27 g (0.001 mol) Bis(trimethylsilyl)tellurium was dissolved in 6 ml of acetonitrile. To the solution, 0.15 g triethoxyantimony was added at room temperature. The reaction was exo-thermic. A black precipitate was formed immediately. The precipitate was filtered out and washed with THF, and dried in air. Energy Dispersive X-ray Analysis (EDX) in conjunction with Scanning Electron Microscopy (SEM) have been used to study the black solid precipitate. The results are shown in Figures 4 and 5. The results indicated that the black solid was a composition of antimony and tellurium. Antimony telluride is insoluble in organic solvents.

### Example 6 Synthesis of GST ternary compound sample

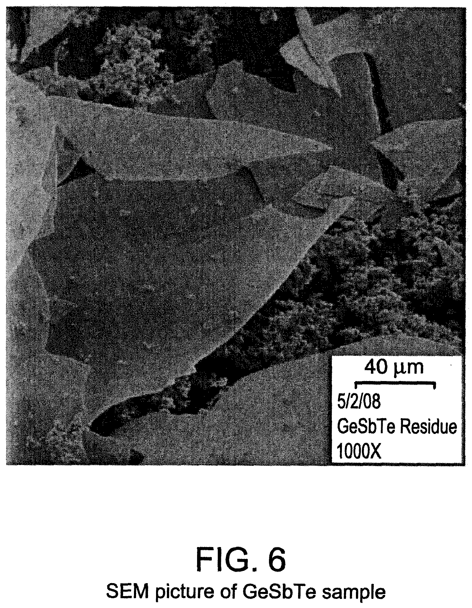

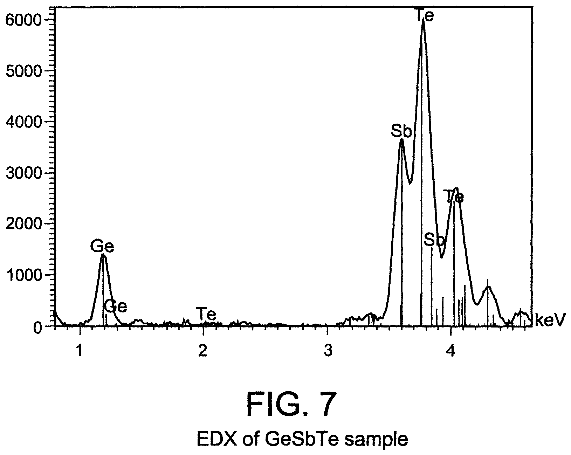

0.27 g (0.001 mol) Bis(trimethylsilyl)tellurium was dissolved in 6 ml of acetonitrile. To the solution, a solution of 0.10 g tetraethoxygermane and 0.10 g triethoxyantimony in 5 ml of acetonitrile was added at room temperature. A black precipitate was formed immediately. The precipitate was filtered out and washed with THF, and dried in air. Energy Dispersive X-ray Analysis (EDX) in conjunction with Scanning Electron Microscopy (SEM) have been used to study the black solid precipitate. The results are shown in Figures 6 and 7. The results indicated that the black solid was a composition of germanium, antimony, and tellurium. The GST material is insoluble in organic solvents.

### Example 7 Formation of GeTe film using ALD technique

Thin films of GeTe were deposited using atomic layer deposition (ALD) technique described in this invention. Ge(OMe)₄ and (Me₃Si)₂Te were used as precursors to form GeTe films. Since TiN is typically used for metal contacts in GST memory cells, 4" (10cm) Si (100) wafers coated with 100nm TiN by sputtering technique were chosen as the substrates for GeTe film deposition. The substrate was heated to 100 °C. The precursors were heated before being fed into the reactor. Specifically, Ge(OMe)₄ was heated to 30 °C, and (Me₃Si)₂Te was heated to 50 °C. The amount of each of these two precursors fed into reactor was then controlled by the duration for which each precursor was fed into the reactor. The ALD sequence was as follows:
(a) pulse Ge(OMe)₄ for 1 second,
(b) purge the reactor with N₂ gas,
(c) pulse (Me₃Si)₂Te for 1 second
(d) purge the reactor with N₂ gas,
(e) repeat steps (a) to (d) for 1000 times (or 1000 cycles).

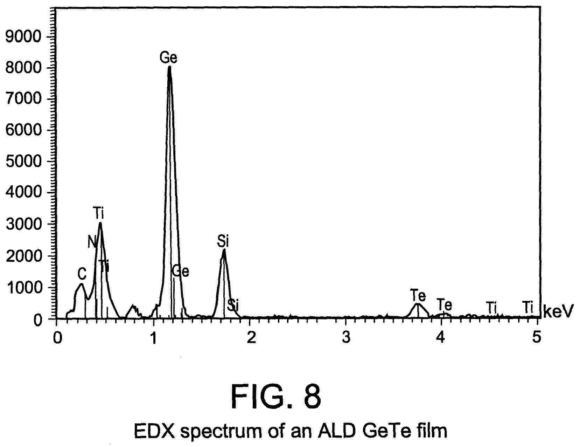

After the deposition was complete, the film was inspected for its compositions using EDX. A typical EDX spectrum of the GeTe films is shown in Figure 8. As can be seen from Figure 8, both Ge and Te were present in the film. The Ti, N and Si peaks came from the Si substrate and TiN coating, while C was due to the SEM chamber contamination.

### Example 8 Formation of SbTe film using ALD technique

Thin films of SbTe were deposited using atomic layer deposition (ALD) technique described in this invention. Sb(OEt)₃ and (Me₃Si)₂Te were used as precursors to form SbTe films. Since TiN is typically used for metal contacts in GST memory cells, 4" (10cm) Si (100) wafers coated with 100nm TiN by sputtering technique were chosen as the substrates for SbTe film deposition. The substrate was heated to 100 °C. The precursors were heated before being fed into the reactor. Specifically, Sb(OEt)₃ and (Me₃Si)₂Te was heated to 30 °C and to 50 °C, respectively. The amount of each of these two precursors fed into reactor was then controlled by the duration for which each precursor was fed into the reactor. The ALD sequence was as follows:
(a) pulse Sb(OEt)₃ for 1 second;
(b) purge the reactor with N₂ gas;
(c) pulse (Me₃Si)₂Te for 1 second;
(d) purge the reactor with N₂ gas;
(e) repeat steps (a) to (d) for 1000 times (or 1000 cycles).

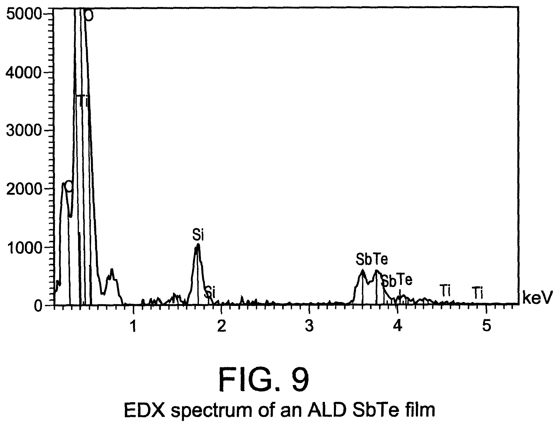

After the deposition was complete, the film was inspected for its compositions using EDX. A typical EDX spectrum of SbTe films is shown in Figure 9. As can be seen from Figure 9, both Sb and Te were present in the film. The Ti, N and Si peaks came from the Si substrate and TiN coating, while C was due to the SEM chamber contamination.

### Example 9 Formation of GeSbTe (GST) film using ALD technique

Thin films of GeSbTe were deposited using atomic layer deposition (ALD) technique described in this invention. Ge(OMe)₄, Sb(OEt)₃ and (Me₃Si)₂Te were used as precursors to form GeSbTe films. Since TiN is typically used for metal contacts in GST memory cells, 4" (10 cm) Si (100) wafers coated with 100nm TiN by sputtering technique were chosen as the substrates for SbTe film deposition. The substrate was heated to 100 °C. The precursors were heated before being fed into the reactor. Specifically, both Ge(OMe)₄ and Sb(OEt)₃ were heated to 30 °C, while (Me₃Si)₂Te was heated to 50 °C. The amount of each of these three precursors fed into reactor was then controlled by the duration for which each precursor was fed into the reactor. The ALD sequence was as follows:
(a) pulse Sb(OEt)₃ for 1 second;
(b) purge the reactor with N₂ gas;
(c) pulse (Me₃Si)₂Te for 1 second;
(d) purge the reactor with N₂ gas;
(e) pulse Ge(OMe)₄ for 1 second;
(f) purge the reactor with N₂ gas;
(g) pulse (Me₃Si)₂Te for 1 second;
(h) purge the reactor with N₂ gas;
(i) repeat steps (a) to (h) for 1000 times (or 1000 cycles).

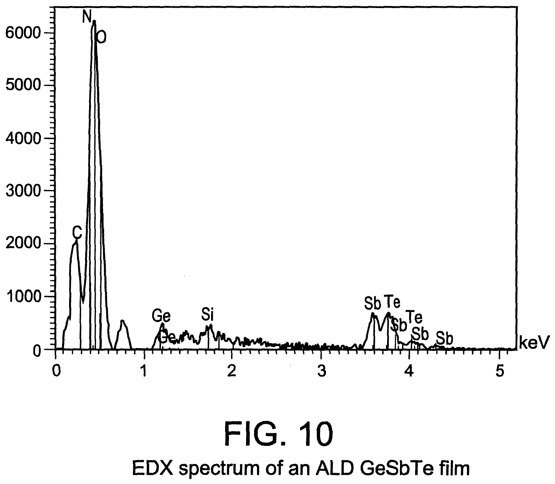

After the deposition was complete, the film was inspected for its compositions using EDX. Atypical EDX spectrum of the GST films is shown in Figure 10. As can be seen from Figure 10, Ge, Sb and Te were all present in the film. The Ti, N and Si peaks came from the Si substrate and TiN coating, while C was due to the SEM chamber contamination.

### Embodiment 1 Deposition of GeTe films using CVD technique

Deposition of GeTe film using Chemical Vapor Deposition (CVD) technique including the following steps:
a) Substrates onto which film is to be deposited are loaded into a CVD reactor;
b) The reactor is purged with N₂ or Ar and pumped down to low pressure of less than 1T (130 Pa) and heated up to a temperature at which film deposition is performed (typically around 200-400 °C);
c) The reactor is then pumped down to a pressure of 500 mT (67 Pa);
d) The precursor for Te, bis(trimethylsilyl)tellurium, and the precursor for Ge tetrakis(dimethylamino)germane are filled into separate containers connected to direct liquid injection (DLI) systems that are connected to the CVD reactor;
e) The vapor of bis(trimethylsilyl)tellurium and the vapor of tetrakis(dimethylamino)germane are then introduced to the CVD reactor at fixed flow rates. The pressure in the reactor, however, is controlled and remains the constant at 500mT(67 Pa);
f) The CVD reaction for forming GeTe films occur and continue until the flows for Te and Ge stop;
g) The CVD reactor is then purged with N₂ or Ar and cooled down to room temperature before the substrates deposited with GeTe films are removed from the reactor.

With the deposition chemistry, highly conformal GeTe films can be deposited on the surface of substrate materials such as silicon, silicon oxide, silicon nitride, titanium nitride.

### Embodiment 2 Deposition of SbTe films using CVD technique

Deposition of SbTe film using Chemical Vapor Deposition (CVD) technique including the following steps:
a) Substrates onto which film is to be deposited are loaded into a CVD reactor;
b) The reactor is purged with N₂ or Ar and pumped down to low pressure of less than 1T (130 Pa) and heated up to a temperature at which film deposition is performed (typically around 200 °C-400 °C);
c) The reactor is then pumped down to a pressure of 500 mT (67 Pa);
d) The precursor for Te, bis(trimethylsilyl)tellurium, and precursor for Sb tris(dimethylamino)antimony are filled into separate containers connected to direct liquid injection (DLI) systems that are connected to the CVD reactor;
e) The vapor of bis(trimethylsilyl)tellurium and the vapor of tris(dimethylamino)antimony are then introduced to the CVD reactor at fixed flow rates. The pressure in the reactor, however, is controlled and remains the constant at 500mT (67 Pa);
f) The CVD reaction for forming SbTe films occur and continue until the flows for Te and Sb stop;
g) The CVD reactor is then purged with N₂ or Ar and cooled down to room temperature before the substrates deposited with SbTe films are removed from the reactor.

With the deposition chemistry, highly conformal SbTe films can be deposited on the surface of substrate materials such as silicon, silicon oxide, silicon nitride, titanium nitride.

### Embodiment 3 Deposition of GeSbTe films using CVD technique

Deposition of GST film using Chemical Vapor Deposition (CVD) technique including the following steps:
a) Substrates onto which film is to be deposited are loaded into a CVD reactor;
b) The reactor is purged with N₂ or Ar and pumped down to low pressure of less than 1T (130 Pa) and heated up to a temperature at which film deposition is performed (typically around 200-400 °C);
c) The reactor is then pumped down to a pressure of 500 mT (67 Pa);
d) The precursor for Te, bis(trimethylsilyl)tellurium, the precursor for Ge tetrakis(dimethylamino)germane, and precursor for Sb, tris(dimethylamino)antimony, are filled into separate containers connected to direct liquid injection (DLI) systems that are connected to the CVD reactor;
e) The vapor of bis(trimethylsilyl)tellurium, the vapor of tetrakis(dimethylamino)germane, and the vapor of tris(dimethylamino)antimony for Sb are then introduced to the CVD reactor at fixed flow rates. The pressure in the reactor, however, is controlled and remains the constant at 500mT (67 Pa);
f) The CVD reaction for forming GeSbTe films occur and continue until the flows for Te, Ge and Sb stop;
g) The CVD reactor is then purged with N₂ or Ar and cooled down to room temperature before the substrates deposited with GST films are removed from the reactor.

With the deposition chemistry, highly conformal GeSbTe films can be deposited on the surface of substrate materials such as silicon, silicon oxide, silicon nitride, titanium nitride.

### Embodiment 4 Deposition of GeSe films using ALD technique

Deposition of GeSe film using atomic layer deposition (ALD) technique including the following steps:
a) Substrates onto which film is to be deposited are loaded into an ALD reactor;
b) The reactor is purged with N₂ and pumped down to low pressure of less than 1T (130 Pa) and heated up to a temperature at which film deposition is performed;
c) A fixed flow rate of the vapor of silylselenium compound (the Se precursor) is introduced to the reactor. The reactor is saturated with this vapor for a short fixed time (typically less than 5 seconds), and then pumped down to 1 torr (130 Pa), followed by purging with N₂;
d) A fixed flow rate of the vapor of alkoxygermane compound (the Ge precursor) is introduced to the reactor. The reactor is saturated with this vapor for a short fixed time (typically less than 5 seconds), and then pumped down to 1 torr (130 Pa), followed by purging with N₂; and
e) Repeat steps c) to d) until a desired thickness of the film is achieved.

With the deposition chemistry, highly conformal GeSe films can be deposited on the surface of substrate materials such as silicon, silicon oxide, silicon nitride, titanium nitride. The process temperature range could be from room temperature to 400° C.

### Embodiment 5 Deposition of SbSe films in using ALD technique

Deposition of SbSe film using atomic layer deposition (ALD) technique including the following steps:
a) Substrates onto which film is to be deposited are loaded into an ALD reactor;
b) The reactor is purged with N₂ and pumped down to low pressure of less than 1T (130 Pa) and heated up to a temperature at which film deposition is performed;
c) A fixed flow rate of the vapor of silylselenium compound (the Se precursor) is introduced to the reactor. The reactor is saturated with this vapor for a short fixed time (typically less than 5 seconds), and then pumped down to 1 torr (130 Pa), followed by purging with N₂;
d) A fixed flow rate of the vapor of alkoxyantimony compound (the Sb precursor) is introduced to the reactor. The reactor is saturated with this vapor for a short fixed time (typically less than 5 seconds), and then pumped down to 1 torr (130 Pa), followed by purging with N₂; and
e) Repeat steps c) to d) until a desired thickness of the film is achieved.

With the deposition chemistry, highly conformal SbSe films can be deposited on the surface of substrate materials such as silicon, silicon oxide, silicon nitride, titanium nitride. The process temperature range could be from room temperature to 400° C.

### Embodiment 6 Deposition of GeSbSe films using ALD technique

Deposition of GeSbSe film using atomic layer deposition (ALD) technique including the following steps:
a) Substrates onto which film is to be deposited are loaded into an ALD reactor;
b) The reactor is purged with N₂ and pumped down to low pressure of less than 1T (130 Pa) and heated up to a temperature at which film deposition is performed;
c) A fixed flow rate of the vapor of silylselenium compound (the Se precursor) is introduced to the reactor. The reactor is saturated with this vapor for a short fixed time (typically less than 5 seconds), and then pumped down to 1 torr (130 Pa), followed by purging with N₂;
d) A fixed flow rate of the vapor of alkoxygermane compound (the Ge precursor) is introduced to the reactor. The reactor is saturated with this vapor for a short fixed time (typically less than 5 seconds), and then pumped down to 1 torr (130 Pa), followed by purging with N₂;
e) A fixed flow rate of the vapor of silylselenium compound (the Se precursor) is introduced to the reactor. The reactor is saturated with this vapor for a short fixed time (typically less than 5 seconds), and then pumped down to 1 torr (130 Pa), followed by purging with N₂;
f) A fixed flow rate of the vapor of alkoxyantimony compound (the Sb precursor) is introduced to the reactor. The reactor is saturated with this vapor for a short fixed time (typically less than 5 seconds), and then pumped down to 1 torr (130 Pa), followed by purging with N₂; and
g) Repeat steps c) to f) until a desired thickness of the film is achieved.

With the deposition chemistry, highly conformal GeSbSe films can be deposited on the surface of substrate materials such as silicon, silicon oxide, silicon nitride, titanium nitride. The process temperature range could be from room temperature to 400° C.

### Embodiment 7 Deposition of GeSe films using CVD technique

Deposition of GeSe film using Chemical Vapor Deposition (CVD) technique including the following steps:
a) Substrates onto which film is to be deposited are loaded into a CVD reactor;
b) The reactor is purged with N₂ or Ar and pumped down to low pressure of less than 1T (130 Pa) and heated up to a temperature at which film deposition is performed (typically around 200-400 °C);
c) The reactor is then pumped down to a pressure of 500 mT (67 Pa);
d) The precursor for Se, silylselenium, and the precursor for Ge, tetrakis(dimethylamino)germane, are filled into separate containers connected to direct liquid injection (DLI) systems that are connected to the CVD reactor;
e) The vapor of silylselenium and the vapor of tetrakis(dimethylamino)germane are then introduced at fixed flow rates to the CVD reactor. The pressure in the reactor, however, is controlled and remains the constant at 500mT (67 Pa);
f) The CVD reaction for forming GeSe films occur and continue until the flows for Ge and Se stop;
g) The CVD reactor is then purged with N₂ or Ar and cooled down to room temperature before the substrates deposited with GeSe films are removed from the reactor.

With the deposition chemistry, highly conformal GeSe films can be deposited on the surface of substrate materials such as silicon, silicon oxide, silicon nitride, titanium nitride.

### Embodiment 8 Deposition of SbSe films using CVD technique

Deposition of SbSe film using Chemical Vapor Deposition (CVD) technique including the following steps:
a) Substrates onto which film is to be deposited are loaded into a CVD reactor;
b) The reactor is purged with N₂ or Ar and pumped down to low pressure of less than 1T (130 Pa) and heated up to a temperature at which film deposition is performed (typically around 200-400 °C);
c) The reactor is then pumped down to a pressure of 500 mT (67 Pa);
d) The precursor for Se, silylselenium, and precursor for Sb, tris(dimethylamino)antimony, are filled into separate containers connected to direct liquid injection (DLI) systems that are connected to the CVD reactor;
e) The vapor of silylselenium and the vapor of tris(dimethylamino)antimony are then introduced at fixed flow rates to the CVD reactor. The pressure in the reactor, however, is controlled and remains the constant at 500mT (67 Pa);
f) The CVD reaction for forming SbSe films occur and continue until the flows for Se and Sb stop;
g) The CVD reactor is then purged with N₂ or Ar and cooled down to room temperature before the substrates deposited with SbSe films are removed from the reactor.

With the deposition chemistry, highly conformal SbSe films can be deposited on the surface of substrate materials such as silicon, silicon oxide, silicon nitride, titanium nitride.

### Embodiment 9 Deposition of GeSbSe films using CVD technique

Deposition of GeSbSe film using Chemical Vapor Deposition (CVD) technique including the following steps:
a) Substrates onto which film is to be deposited are loaded into a CVD reactor;
b) The reactor is purged with N₂ or Ar and pumped down to low pressure of less than 1T (130 Pa) and heated up to a temperature at which film deposition is performed (typically around 200-400 °C);
c) The reactor is then pumped down to a pressure of 500 mT (67 Pa);
d) The precursor for Se, silylselenium, the precursor for Ge, tetrakis(dimethylamino)germane, and precursor for Sb, tris(dimethylamino)antimony, are filled into separate containers connected to direct liquid injection (DLI) systems that are connected to the CVD reactor;
e) The vapor of silylselenium, the vapor of tetrakis(dimethylamino)germane and the vapor of tris(dimethylamino)antimony are then introduced at fixed flow rates to the CVD reactor. The pressure in the reactor, however, is controlled and remains the constant at 500mT (67 Pa);
f) The CVD reaction for forming GeSbSe films occur and continue until the flows for Se, Ge, and Sb stop;
g) The CVD reactor is then purged with N₂ or Ar and cooled down to room temperature before the substrates deposited with GeSbSe films are removed from the reactor.
With the deposition chemistry, highly conformal GeSbSe films can be deposited on the surface of substrate materials such as silicon, silicon oxide, silicon nitride, titanium nitride

### Embodiment 10 Deposition of Ge₂Sb₂Te₅ films using CVD technique

Deposition of GST film using Chemical Vapor Deposition (CVD) technique including the following steps:
a) Substrates onto which film is to be deposited are loaded into a CVD reactor;
b) The reactor is purged with N₂ or Ar and pumped down to low pressure of less than 1T (130 Pa) and heated up to a temperature at which film deposition is performed (typically around 200-400 °C);
c) The reactor is then pumped down to a pressure of 500 mT (67 Pa);
d) The precursor for Te, bis(trimethylsilyl)tellurium, the precursor for Ge, Ge(OR)₂, and the precursor for Sb, tris(dimethylamino)antimony, are filled into separate containers connected to direct liquid injection (DLI) systems that are connected to the CVD reactor;
e) The vapor of bis(trimethylsilyl)tellurium, the vapor of Ge(OR)₂ and the vapor of tris(dimethylamino)antimony are then introduced to the CVD reactor at fixed flow rates. The pressure in the reactor, however, is controlled and remains constant at 500mT (67 Pa);
f) The CVD reaction for forming Ge₂Sb₂Te₅ films occur and continue until the flows for Te, Ge and Sb stop;
g) The CVD reactor is then purged with N₂ or Ar and cooled down to room temperature before the substrates deposited with GST films are removed from the reactor.

With the deposition chemistry, highly conformal Ge₂Sb₂Te₅ films can be deposited on the surface of substrate materials such as silicon, silicon oxide, silicon nitride, titanium nitride.

### Embodiment 11 Deposition of Ge₂Sb₂Te₅ films using CVD technique

Deposition of GST film using Chemical Vapor Deposition (CVD) technique including the following steps:
a) Substrates onto which film is to be deposited are loaded into a CVD reactor;
b) The reactor is purged with N₂ or Ar and pumped down to low pressure of less than 1T (130 Pa) and heated up to a temperature at which film deposition is performed (typically around 200-400 °C);
c) The reactor is then pumped down to a pressure of 500 mT (67 Pa);
d) The precursor for Te, bis(trimethylsilyl)tellurium, the precursor for Ge, Ge(NR₂)₂, and the precursor for Sb, tris(dimethylamino)antimony, are filled into separate containers connected to direct liquid injection (DLI) systems that are connected to the CVD reactor;
e) The vapor of bis(trimethylsilyl)tellurium, the vapor of Ge(NR₂)₂, and the vapor of tris(dimethylamino)antimony are then introduced to the CVD reactor at fixed flow rates. The pressure in the reactor, however, is controlled and remains constant at 500mT (67 Pa);
f) The CVD reaction for forming Ge₂Sb₂Te₅ films occur and continue until the flows for Te, Ge and Sb stop;
g) The CVD reactor is then purged with N₂ or Ar and cooled down to room temperature before the substrates deposited with GST films are removed from the reactor.

With the deposition chemistry, highly conformal Ge₂Sb₂Te₅ films can be deposited on the surface of substrate materials such as silicon, silicon oxide, silicon nitride, titanium nitride.

### Example 12 Formation of Ge₂Sb₂Te₅ film using ALD technique

Thin films of Ge₂Sb₂Te₅ were deposited using atomic layer deposition (ALD) technique described in this invention. Ge(OR)₂, Sb(OEt)₃ and (Me₃Si)₂Te were used as precursors to form Ge₂Sb₂Te₅ films. Since TiN is typically used for metal contacts in GST memory cells, 4" (10 cm) Si (100) wafers coated with 100nm TiN by sputtering technique were chosen as the substrates for SbTe film deposition. The substrate was heated to 100 °C. The precursors were heated before being fed into the reactor. Specifically, both Ge(OR)₂ and Sb(OEt)₃ were heated to 30 °C, while (Me₃Si)₂Te was heated to 50 °C. The amount of each of these three precursors fed into reactor was then controlled by the duration for which each precursor was fed into the reactor. The ALD sequence was as follows:
a) pulse Sb(OEt)₃ for 1 second;
b) purge the reactor with N₂ gas;
c) pulse (Me₃Si)₂Te for 1 second;
d) purge the reactor with N₂ gas;
e) pulse Ge(OR)₂ for 1 second;
f) purge the reactor with N₂ gas;
g) pulse (Me₃Si)₂Te for 1 second;
h) purge the reactor with N₂ gas;
repeat steps (a) to (h) for 1000 times (or 1000 cycles).

After the deposition was complete, the film was inspected for its compositions using EDX.

### Example 13 Formation of Ge₂Sb₂Te₅ film using ALD technique

Thin films of Ge₂Sb₂Te₅ were deposited using atomic layer deposition (ALD) technique described in this invention. Ge(NR₂)₂, Sb(OEt)₃ and (Me₃Si)₂Te were used as precursors to form Ge₂Sb₂Te₅ films. Since TiN is typically used for metal contacts in GST memory cells, 4" (10 cm) Si (100) wafers coated with 100nm TiN by sputtering technique were chosen as the substrates for SbTe film deposition. The substrate was heated to 100 °C. The precursors were heated before being fed into the reactor. Specifically, both Ge(NR₂)₂ and Sb(OEt)₃ were heated to 30 °C, while (Me₃Si)₂Te was heated to 50 °C. The amount of each of these three precursors fed into reactor was then controlled by the duration for which each precursor was fed into the reactor. The ALD sequence was as follows:
a) pulse Sb(OEt)₃ for 1 second;
b) purge the reactor with N₂ gas;
c) pulse (Me₃Si)₂Te for 1 second;
d) purge the reactor with N₂ gas;
e) pulse Ge(NR₂)₂ for 1 second;
f) purge the reactor with N₂ gas;
g) pulse (Me₃Si)₂Te for 1 second;
h) purge the reactor with N₂ gas;
repeat steps (a) to (h) for 1000 times (or 1000 cycles).

After the deposition was complete, the film was inspected for its compositions using EDX.

## Claims

1. A process of making a metal chalcogenide alloy film on a substrate comprising:
contacting the substrate with a silyl-chalcogen selected from the group consisting of silyltelluriums and silylseleniums;
contacting the substrate with a germanium compound having a general formula selected from the group consisting of Ge(OR)₂, Ge(NR₂)₂ and combinations thereof;
wherein each R is independently selected from the group consisiting of an alkyl group having 1 to 10 carbons in linear, branched or cyclic form, or an aromatic group; and
a functionalized alkyl group with the general structure of:
R⁵NR⁶R⁷;
R⁵OR⁶;
or
R⁵SR⁶;
wherein R⁵ is an alkylene group having 2 to 6 carbons in linear, branched or cyclic form, or an aromatic group; and R⁶⁻⁷ are each independently selected from the group consisting of hydrogen, alkyl groups having 1 to 6 carbons in linear, branched or cyclic form, and aromatic groups;
and
contacting the substrate with a metal compound having a general formula of:
MXₙ;
wherein: M is selected from the group consisting of Sb, In, Sn, Ga, Bi, Ag, Cu, Zr, Hf, Hg, Cd, Zn and noble metals;
X is a nucleophilic group selected from the group consisting of OR(alkoxy), F(fluorine), Cl (chlorine), Br (bromine), NR₂(amino), CN (cyano), OCN (cyanate), SCN (thiocyanate), diketonate, carboxylic groups and mixtures thereof; and
n=1 to 5; wherein when n >1, each X is individually selected from selected from the group consisting of OR(alkoxy), F(fluorine), Cl (chlorine), Br (bromine), NR₂(amino), CN (cyano), OCN (cyanate), SCN (thiocyanate), diketonate, and carboxylic groups.

2. The process of Claim 1 wherein
the silyltellurium is selected from the group consisting of disilyltellurium having a general formula: (R¹R²R³Si)₂Te, alkylsilyltellurium having a general formula:
(R¹R²R³Si)TeR⁴,
and mixtures thereof;
wherein R¹, R², R³, and R⁴ are each independently selected from the group consisting of hydrogen, alkyl groups having 1 - 10 carbons in linear, branched, or cyclic form, without or with double bonds, and aromatic groups; and
the silylselenium is selected from the group consisting of disilylselenium having a general formula: (R¹R²R³Si)₂Se, alkylsilylselenium having a general formula:
(R¹R²R³Si)SeR⁴,
and mixtures thereof;
wherein R¹, R², R³, and R⁴, are each independently selected from the group consisting of hydrogen, alkyl groups having 1 - 10 carbons in linear, branched, or cyclic form, without or with double bonds, and aromatic groups.

3. The process of Claim 2 wherein
the silyltellurium is selected from the group consisting of bis(trimethylsilyl)tellurium, bis(dimethylsilyl)tellurium, bis(triethylsilyl)tellurium, bis(diethylsilyl)tellurium, bis(phenyldimethylsilyl)tellurium, bis(t-butyldimethylsilyl)tellurium, dimethylsilylmethyltellurium, dimethylsilylphenyltellurium, dimethylsilyl-n-butyltellurium, dimethylsilyl-t-butyltellurium, trimethylsilylmethyltellurium, trimethylsilylphenyltellurium, trimethylsilyl-n-butyltellurium, and trimethylsilyl-t-butyltellurium; and
the silylselenium is selected from the group consisting of bis(trimethylsilyl)selenium, bis(dimethylsilyl)selenium, bis(triethylsilyl)selenium, bis(diethylsilyl) selenium, bis(phenyldimethylsilyl) selenium, bis(t-butyldimethylsilyl) selenium, dimethylsilylmethyl selenium, dimethylsilylphenyl selenium, dimethylsilyl-n-butyl selenium, dimethylsilyl-t-butyl selenium, trimethylsilylmethyl selenium, trimethylsilylphenyl selenium, trimethylsilyl-n-butyl selenium, and trimethylsilyl-t-butylselenium.

4. The process of any preceding claim, wherein the germanium compound is selected from the group consisting of Ge(OBu^{t})₂, Ge(OCH₂CH₂NMe₂)₂, Ge(OCH(Me)CH₂CH₂NMe₂)₂, Ge(OC(Me)₂CH₂CH₂NMe₂)₂, Ge(OCH(Me)CH₂CH₂NEt₂)₂, Ge(OC(Me)₂CH₂CH₂NEt₂)₂, Ge(OCH₂CH₂OMe)₂, Ge(OCH₂CH₂OEt)₂, Ge(OCH₂CH₂OPrⁱ)₂, Ge(OCH(Me)CH₂cH₂OMe)₂, Ge(OCH(Me)CH₂CH₂OEt)₂, Ge(OCH(Me)CH₂CH₂OPrⁱ)₂, Ge(OC(Me)₂CH₂CH₂OMe)₂, Ge(OC(Me)₂CH₂CH₂OEt)₂, Ge(OC(Me)₂CH₂CH₂OPrⁱ)₂, Ge(OCH₂CH₂SMe)₂, Ge(N(Me)CH₂CH₂NMe₂)₂, Ge(N(Me)CH₂CH₂NEt₂)₂.

5. The process of any preceding claim, wherein the metal compound is an antimony compound selected from the group consisting of: (a) (RO)₃Sb, where R is an alkyl group with 1 to 10 carbons in linear, branched or cyclic form; (b) (R¹R²N)₃Sb, where R¹ and R² are each independently selected from the group consisting of alkyl groups with 1 to 10 carbons in linear, branched or cyclic form; and (c) antomony halide with the general formula: SbX₃ or SbX₅, where X is F, Cl, or Br.

6. The process of Claim 5, the antimony compound is selected from the group consisting of Sb(OMe)₃, Sb(OEt)₃, Sb(NMe₂)₃, Sb(NMeEt)₃, and Sb(NEt₂)₂.

7. The process of any preceding claim, wherein the process is selected from the group consisting of atomic layer deposition (ALD) processes, Chemical Vapor Deposition (CVD) processes and solution wet chemistry.

8. The process of any preceding claim, wherein the metal chalcogenide alloy film is germanium-antimony-tellurium with a composition of Ge₂Sb₂Te₅.

9. The process of any preceding claim, wherein the process is an ALD process of making a metal chalcogenide alloy film on a substrate in an ALD reactor comprising steps of:
(a) contacting the substrate with a silyl-chalcogen selected from the group consisting of silyltelluriums and silylseleniums; and
(b) contacting the substrate with a germanium compound having a general formula selected from the group consisting of Ge(OR)₂, Ge(NR₂)₂ and combinations thereof;
wherein each R is independently selected from the group consisiting of an alkyl group having 1 to 10 carbons in linear, branched or cyclic form, or an aromatic group; and
a functionalized alkyl group with the general structure of:
R⁵NR⁶R⁷;
R⁵OR⁶;
or
R⁵SR⁶;
wherein R⁵ is an alkylene group having 2 to 6 carbons in linear, branched or cyclic form, or an aromatic group; R⁶⁻⁷ are each independently selected from the group consisting of hydrogen, alkyl groups having 1 to 6 carbons in linear, branched, or cyclic form, and aromatic groups;
(c) contacting the substrate with a silyl-chalcogen selected from the group consisting of silyltelluriums and silylseleniums;
(d) contacting the substrate with a metal compound having a general formula of: MXₙ;
wherein M is selected from the group consisting of Sb, In, Sn, Ga, Bi, Ag, Cu, Zr, Hf, Hg, Cd, Zn and noble metals; X is a nucleophilic group selected from the group consisting of OR(alkoxy), F(fluorine), Cl (chlorine), Br (bromine), NR₂(amino), CN (cyano), OCN (cyanate), SCN (thiocyanate), diketonate, carboxylic groups and mixtures thereof; and n=1 to 5; wherein when n >1, each X is individually selected from selected from the group consisting of OR(alkoxy), F(fluorine), Cl (chlorine), Br (bromine), NR₂(amino), CN (cyano), OCN (cyanate), SCN (thiocyanate), diketonate, and carboxylic groups;
(e) optionally, purging the ALD reactor with inert gas selected from the group consisting of N₂, Ar and mixtures thereof;
wherein the purging step (e) is performed before the contacting step (a) and after each contacting step; and
(f) all steps are repeated to achieve a desired thickness of the film.

10. The process of any preceding claim, wherein the process is a CVD process of making a metal chalcogenide alloy film on a substrate in an CVD reactor comprising steps of:
(a) contacting the substrate with a silyl-chalcogen selected from the group consisting of silyltelluriums and silylseleniums;
(b) contacting the substrate with a germanium compound having a general formula selected from the group consisting of Ge(OR)₂, Ge(NR₂)₂ and combinations thereof;
wherein each R is independently selected from the group consisiting of an alkyl group having 1 to 10 carbons in linear, branched or cyclic form, or an aromatic group; and
a functionalized alkyl group with the general structure of:
R⁵NR⁶R⁷;
R⁵OR⁶;
or
R⁵SR⁶;
wherein R⁵ is an alkylene group having 2 to 6 carbons in linear, branched, or cyclic form, or an aromatic group; R⁶⁻⁷ are each independently selected from the group consisting of hydrogen, alkyl groups having 1 to 6 carbons in linear, branched, or cyclic form, and aromatic groups;
(c) contacting the substrate with a metal compound having a general formula of: MXₙ;
wherein M is selected from the group consisting of Sb, In, Sn, Ga, Bi, Ag, Cu, Zr, Hf, Hg, Cd, Zn and noble metals; X is a nucleophilic group selected from the group consisting of OR(alkoxy), F(fluorine), Cl (chlorine), Br (bromine), NR₂(amino), CN (cyano), OCN (cyanate), SCN (thiocyanate), diketonate, carboxylic groups and mixtures thereof; and n=1 to 5; wherein when n >1, each X is individually selected from selected from the group consisting of OR(alkoxy), F(fluorine), Cl (chlorine), Br (bromine), NR₂(amino), CN (cyano), OCN (cyanate), SCN (thiocyanate), diketonate, and carboxylic groups;
(d) purging the CVD reactor with inert gas selected from the group consisting of N₂, Ar and mixtures thereof; and
(e) pumping the CVD reactor down to a pressure of less than 130 Pa (1 Torr); wherein the contacting steps (a) to (c) may be carried out sequentially or concurrently
and wherein the purging and pumping steps (d) and (e) are performed before the first contacting step.

## Patentansprüche

1. Verfahren zur Herstellung eines Metallchalkogenidlegierungsfilms auf einem Substrat, das Folgendes umfasst:
Kontaktieren des Substrats mit einem Silyl-Chalkogen, das aus der Gruppe ausgewählt ist, die aus Silyltelluren und Silylselenen besteht;
Kontaktieren des Substrats mit einer Germaniumverbindung mit einer allgemeinen Formel, die aus der Gruppe ausgewählt ist, die aus Ge(OR)₂, Ge(NR₂)₂ und Kombinationen davon besteht;
wobei jedes R unabhängig aus der Gruppe ausgewählt ist, die besteht aus
einer Alkylgruppe mit 1 bis 10 Kohlenstoffatomen in linearer, verzweigter oder zyklischer Form, oder einer aromatischen Gruppe; und
einer funktionalisierten Alkylgruppe mit der allgemeinen Struktur von:
R⁵NR⁶R⁷;
R⁵OR⁶;
oder
R⁵SR⁶;
wobei R⁵ eine Alkylengruppe mit 2 bis 6 Kohlenstoffatomen in linearer, verzweigter oder zyklischer Form oder eine aromatische Gruppe ist; und R⁶⁻⁷ jeweils unabhängig aus der Gruppe ausgewählt sind, die aus Wasserstoff, Alkylgruppen mit 1 bis 6 Kohlenstoffatomen in linearer, verzweigter oder zyklischer Form und aromatischen Gruppen besteht; und
Kontaktieren des Substrats mit einer Metallverbindung mit einer allgemeinen Formel von:
MXₙ;
wobei: M aus der Gruppe ausgewählt ist, die aus Sb, In, Sn, Ga, Bi, Ag, Cu, Zr, Hf, Hg, Cd, Zn und Edelmetallen besteht;
X eine nukleophile Gruppe ist, die aus der Gruppe ausgewählt ist, die aus OR (Alkoxy), F (Fluor), Cl (Chlor), Br (Brom), NR₂ (Amino), CN (Cyano), OCN (Cyanat), SCN (Thiocyanat), Diketonat, Carbonsäuregruppen und Gemischen davon besteht; und
n=1 bis 5; wobei, wenn n > 1, jedes X individuell aus der Gruppe ausgewählt ist, die aus OR (Alkoxy), F (Fluor), Cl (Chlor), Br (Brom), NR₂ (Amino), CN (Cyano), OCN (Cyanat), SCN (Thiocyanat), Diketonat und Carbonsäuregruppen besteht.

2. Verfahren nach Anspruch 1, wobei
das Silyltellur aus der Gruppe ausgewählt ist, die aus Disilyltellur mit einer allgemeinen Formel: (R¹R²R³Si)₂Te, Alkylsilyltellur mit einer allgemeinen Formel: (R¹R²R³Si)TeR⁴ und Gemischen davon besteht;
wobei R¹, R², R³ und R⁴ jeweils unabhängig aus der Gruppe ausgewählt sind, die aus Wasserstoff, Alkylgruppen mit 1 - 10 Kohlenstoffatomen in linearer, verzweigter oder zyklischer Form ohne oder mit Doppelbindungen und aromatischen Gruppen besteht; und
das Silylselen aus der Gruppe ausgewählt ist, die aus Disilylselen mit einer allgemeinen Formel: (R¹R²R³Si)₂Se, Alkylsilylselen mit einer allgemeinen Formel: (R¹R²R³Si)SeR⁴ und Gemischen davon besteht;
wobei R¹, R², R³ und R⁴ jeweils unabhängig aus der Gruppe ausgewählt sind, die aus Wasserstoff, Alkylgruppen mit 1 - 10 Kohlenstoffatomen in linearer, verzweigter oder zyklischer Form ohne oder mit Doppelbindungen und aromatischen Gruppen besteht.

3. Verfahren nach Anspruch 2, wobei
das Silyltellur aus der Gruppe ausgewählt ist, die aus Bis(trimethylsilyl)tellur, Bis(dimethylsilyl)tellur, Bis(triethylsilyl)tellur, Bis(diethylsilyl)tellur, Bis(phenyldimethylsilyl)tellur, Bis(t-butyldimethylsilyl)tellur, Dimethylsilylmethyltellur, Dimethylsilylphenyltellur, Dimethylsilyl-n-butyltellur, Dimethylsilyl-t-butyltellur, Trimethylsilylmethyltellur, Trimethylsilylphenyltellur, Trimethylsilyl-n-butyltellur und Trimethylsilyl-t-butyltellur besteht; und
das Silylselen aus der Gruppe ausgewählt ist, die aus Bis(trimethylsilyl)selen, Bis(dimethylsilyl)selen, Bis(triethylsilyl)selen, Bis(diethylsilyl)selen, Bis(phenyldimethylsilyl)selen, Bis(t-butyldimethylsilyl)selen, Dimethylsilylmethylselen, Dimethylsilylphenylselen, Dimethylsilyl-n-butylselen, Dimethylsilyl-t-butylselen, Trimethylsilylmethylselen, Trimethylsilylphenylselen, Trimethylsilyl-n-butylselen und Trimethylsilyl-t-butylselen besteht.

4. Verfahren nach einem vorangehenden Anspruch, wobei die Germaniumverbindung aus der Gruppe ausgewählt ist, die aus Ge(OBu^{t})₂, Ge(OCH₂CH₂NMe₂)₂, Ge(OCH(Me)CH₂CH₂NMe₂)₂, Ge(OC(Me)₂CH₂CH₂NMe₂)₂, Ge(OCH(Me)CH₂CH₂NEt₂)₂, Ge(OC(Me)₂CH₂CH₂NEt₂)₂, Ge(OCH₂CH₂OMe)₂, Ge(OCH₂CH₂OEt)₂, Ge(OCH₂CH₂OPrⁱ)₂, Ge(OCH(Me)CH₂CH₂OMe)₂, Ge(OCH(Me)CH₂CH₂OEt)₂, Ge(OCH(Me)CH₂CH₂OPrⁱ)₂, Ge(OC(Me)₂CH₂CH₂OMe)₂, Ge(OC(Me)₂CH₂CH₂OEt)₂, Ge(OC(Me)₂CH₂CH₂OPrⁱ)₂, Ge(OCH₂CH₂SMe)₂, Ge(N(Me)CH₂CH₂NMe₂)₂, Ge(N(Me)CH₂CH₂NEt₂)₂ besteht.

5. Verfahren nach einem vorangehenden Anspruch, wobei die Metallverbindung eine Antimonverbindung ist, die aus der Gruppe ausgewählt ist, die besteht aus: (a) (RO)₃Sb, wobei R eine Alkylgruppe mit 1 bis 10 Kohlenstoffatomen in linearer, verzweigter oder zyklischer Form ist; (b) (R¹R²N)₃Sb, wobei R¹ und R² jeweils unabhängig aus der Gruppe ausgewählt sind, die aus Alkylgruppen mit 1 bis 10 Kohlenstoffatomen in linearer, verzweigter oder zyklischer Form besteht; und (c) Antimonhalogenid mit der allgemeinen Formel: SbX₃ oder SbX₅, wobei X F, Cl oder Br ist.

6. Verfahren nach Anspruch 5, wobei die Antimonverbindung aus der Gruppe ausgewählt ist, die aus Sb(OMe)₃, Sb(OEt)₃, Sb(NMe₂)₃, Sb(NMeEt)₃ und Sb(NEt₂)₂ besteht.

7. Verfahren nach einem vorangehenden Anspruch, wobei das Verfahren aus der Gruppe ausgewählt ist, die aus Atomschichtabscheidungs-Verfahren (ALD-Verfahren), Verfahren der chemischen Gasphasenabscheidung (CVD) und Lösungsnasschemie besteht.

8. Verfahren nach einem vorangehenden Anspruch, wobei der Metallchalkogenidlegierungsfilm Germanium-Antimon-Tellur mit einer Zusammensetzung von Ge₂Sb₂Te₅ ist.

9. Verfahren nach einem vorangehenden Anspruch, wobei das Verfahren ein ALD-Verfahren zur Herstellung eines Metallchalkogenidlegierungsfilms auf einem Substrat in einem ALD-Reaktor ist, das die Schritte umfasst:
(a) Kontaktieren des Substrats mit einem Silyl-Chalkogen, das aus der Gruppe ausgewählt ist, die aus Silyltelluren und Silylselenen besteht; und
(b) Kontaktieren des Substrats mit einer Germaniumverbindung mit einer allgemeinen Formel, die aus der Gruppe ausgewählt ist, die aus Ge(OR)₂, Ge(NR₂)₂ und Kombinationen davon besteht;
wobei jedes R unabhängig aus der Gruppe ausgewählt ist, die besteht aus einer Alkylgruppe mit 1 bis 10 Kohlenstoffatomen in linearer, verzweigter oder zyklischer Form, oder einer aromatischen Gruppe; und
einer funktionalisierten Alkylgruppe mit der allgemeinen Struktur von:
R⁵NR⁶R⁷;
R⁵OR⁶;
oder
R⁵SR⁶;
wobei R⁵ eine Alkylengruppe mit 2 bis 6 Kohlenstoffatomen in linearer, verzweigter oder zyklischer Form oder eine aromatische Gruppe ist; und R⁶⁻⁷ jeweils unabhängig aus der Gruppe ausgewählt sind, die aus Wasserstoff, Alkylgruppen mit 1 bis 6 Kohlenstoffatomen in linearer, verzweigter oder zyklischer Form und aromatischen Gruppen besteht;
(c) Kontaktieren des Substrats mit einem Silyl-Chalkogen, das aus der Gruppe ausgewählt ist, die aus Silyltelluren und Silylselenen besteht;
(d) Kontaktieren des Substrats mit einer Metallverbindung mit einer allgemeinen Formel von:
MXₙ;
wobei M aus der Gruppe ausgewählt ist, die aus Sb, In, Sn, Ga, Bi, Ag, Cu, Zr, Hf, Hg, Cd, Zn und Edelmetallen besteht; X eine nukleophile Gruppe ist, die aus der Gruppe ausgewählt ist, die aus OR (Alkoxy), F (Fluor), Cl (Chlor), Br (Brom), NR₂ (Amino), CN (Cyano), OCN (Cyanat), SCN (Thiocyanat), Diketonat, Carbonsäuregruppen und Gemischen davon besteht;
und n=1 bis 5; wobei, wenn n > 1, jedes X individuell aus der Gruppe ausgewählt ist, die aus OR (Alkoxy), F (Fluor), Cl (Chlor), Br (Brom), NR₂ (Amino), CN (Cyano), OCN (Cyanat), SCN (Thiocyanat), Diketonat und Carbonsäuregruppen besteht;
(e) wahlweise Spülen des ALD-Reaktors mit einem Inertgas, das aus der Gruppe ausgewählt ist, die aus N₂, Ar und Gemischen davon besteht;
wobei der Spülschritt (e) vor dem Kontaktierungsschritt (a) und nach jedem Kontaktierungsschritt durchgeführt wird; und
(f) alle Schritte wiederholt werden, um eine gewünschte Dicke des Films zu erreichen.

10. Verfahren nach einem vorangehenden Anspruch, wobei das Verfahren ein CVD-Verfahren zur Herstellung eines Metallchalkogenidlegierungsfilms auf einem Substrat in einem CVD-Reaktor ist, das die Schritte umfasst:
(a) Kontaktieren des Substrats mit einem Silyl-Chalkogen, das aus der Gruppe ausgewählt ist, die aus Silyltelluren und Silylselenen besteht;
(b) Kontaktieren des Substrats mit einer Germaniumverbindung mit einer allgemeinen Formel, die aus der Gruppe ausgewählt ist, die aus Ge(OR)₂, Ge(NR₂)₂ und Kombinationen davon besteht;
wobei jedes R unabhängig aus der Gruppe ausgewählt ist, die besteht aus einer Alkylgruppe mit 1 bis 10 Kohlenstoffatomen in linearer, verzweigter oder zyklischer Form, oder einer aromatischen Gruppe; und
einer funktionalisierten Alkylgruppe mit der allgemeinen Struktur von:
R⁵NR⁶R⁷;
R⁵OR⁶;
oder
R⁵SR⁶;
wobei R⁵ eine Alkylengruppe mit 2 bis 6 Kohlenstoffatomen in linearer, verzweigter oder zyklischer Form oder eine aromatische Gruppe ist; und R⁶⁻⁷ jeweils unabhängig aus der Gruppe ausgewählt sind, die aus Wasserstoff, Alkylgruppen mit 1 bis 6 Kohlenstoffatomen in linearer, verzweigter oder zyklischer Form und aromatischen Gruppen besteht;
(c) Kontaktieren des Substrats mit einer Metallverbindung mit einer allgemeinen Formel von:
MXₙ;
wobei M aus der Gruppe ausgewählt ist, die aus Sb, In, Sn, Ga, Bi, Ag, Cu, Zr, Hf, Hg, Cd, Zn und Edelmetallen besteht; X eine nukleophile Gruppe ist, die aus der Gruppe ausgewählt ist, die aus OR (Alkoxy), F (Fluor), Cl (Chlor), Br (Brom), NR₂ (Amino), CN (Cyano), OCN (Cyanat), SCN (Thiocyanat), Diketonat, Carbonsäuregruppen und Gemischen davon besteht;
und n=1 bis 5; wobei, wenn n > 1, jedes X individuell aus der Gruppe ausgewählt ist, die aus OR (Alkoxy), F (Fluor), Cl (Chlor), Br (Brom), NR₂ (Amino), CN (Cyano), OCN (Cyanat), SCN (Thiocyanat), Diketonat und Carbonsäuregruppen besteht;
(d) Spülen des CVD-Reaktors mit einem Inertgas, das aus der Gruppe ausgewählt ist, die aus N₂, Ar und Gemischen davon besteht; und
(e) Abpumpen des CVD-Reaktors auf einen Druck von weniger als 130 Pa (1 Torr);
wobei die Kontaktierungsschritte (a) bis (c) nacheinander oder gleichzeitig ausgeführt werden können und wobei die Spül- und Pumpschritte (d) und (e) vor dem ersten Kontaktierungsschritt durchgeführt werden.

## Revendications

1. Procédé de fabrication d'un film d'alliage de chalcogénure métallique sur un substrat comprenant :
la mise en contact du substrat avec un silyl-chalcogène choisi parmi le groupe constitué de silyle de tellures et de silyle de séléniums ;
la mise en contact du substrat avec un composé germanium représenté par une formule générale choisie parmi le groupe constitué de Ge(OR)₂, Ge(NR₂)₂ et des combinaisons de celles-ci ;
dans laquelle chaque R est indépendamment choisi parmi le groupe constitué d'un groupe alkyle ayant de 1 à 10 atomes de carbone sous forme linéaire, ramifiée ou cyclique, ou un groupe aromatique ; et
d'un groupe alkyle fonctionnalisé avec la structure générale suivante :
R⁵NR⁶R⁷;
R⁵OR⁶ ;
ou
R⁵SR⁶ ;
dans laquelle R⁵ est un groupe alkylène ayant de 2 à 6 atomes de carbone sous forme linéaire, ramifiée ou cyclique, ou un groupe aromatique ; et R⁶⁻⁷ sont chacun indépendamment choisi parmi le groupe constitué d'hydrogène, de groupes alkyle ayant de 1 à 6 atomes de carbone sous forme linéaire, ramifiée ou cyclique, et des groupes aromatiques ;
et
la mise en contact du substrat avec un composé métallique représenté par une formule générale suivante :
MXₙ ;
dans laquelle : M est choisi parmi le groupe constitué de Sb, In, Sn, Ga, Bi, Ag, Cu, Zr, Hf, Hg, Cd, Zn et des métaux nobles ;
X est un groupe nucléophile choisi parmi le groupe constitué de OR(alcoxy), de F(fluor), de Cl(chlore), de Br(brome), de NR₂(amino), de CN(cyano), de OCN(cyanate), de SCN(thiocyanate), de dicétonate, de groupes carboxyliques et des mélanges de ceux-ci ; et
n = 1 à 5 ; dans lequel lorsque n > 1, chaque X est individuellement choisi parmi le groupe constitué de OR(alcoxy), de F(fluor), de Cl(chlore), de Br(brome), de NR₂(amino), de CN(cyano), de OCN(cyanate), de SCN(thiocyanate), de dicétonate, et de groupes carboxyliques.

2. Procédé selon la revendication 1 dans lequel
le silyle de tellure est choisi parmi le groupe constitué de disilyle de tellure représenté par une formule générale : (R¹R²R³Si)₂Te, d'alkylsilyle de tellure représenté par une formule générale : (R¹R²R³Si)TeR⁴, et des mélanges de ceux-ci ; dans laquelle R¹, R², R³, et R⁴ sont chacun indépendamment choisi parmi le groupe constitué d'hydrogène, de groupes alkyle ayant de 1 à 10 atomes de carbone sous forme linéaire, ramifiée, ou cyclique, avec ou sans liaisons doubles, et des groupes aromatiques ; et
le silyle de sélénium est choisi parmi le groupe constitué de disilyle de sélénium représenté par une formule générale : (R¹R²R³Si)₂Se, d'alkylsilyle de sélénium représenté par une formule générale : (R¹R²R³Si)SeR⁴, et des mélanges de ceux-ci ; dans lequel R¹, R², R³, et R⁴ sont chacun indépendamment choisi parmi le groupe constitué d'hydrogène, de groupes alkyle ayant de 1 à 10 atomes de carbone sous forme linéaire, ramifiée, ou cyclique, avec ou sans liaisons doubles, et des groupes aromatiques.

3. Procédé selon la revendication 2 dans lequel
le silyle de tellure est choisi parmi le groupe constitué de tellure de bis(triméthylsilyle), de tellure de bis(diméthylsilyle), de tellure de bis(triéthylsilyle), de tellure de bis(diéthylsilyle), de tellure de bis(phényldiméthylsilyle), de tellure de bis(t-butyldiméthylsilyle), de tellure de diméthylsilylméthyle, de tellure de diméthylsilylphényle, de tellure de diméthylsilyl-n-butyle, de tellure de diméthylsilyl-t-butyle, de tellure de triméthylsilylméthyle, de tellure de triméthylsilylphényle, de tellure de triméthylsilyl-n-butyle, et de tellure de triméthylsilyl-t-butyle ; et
le silyle de sélénium est choisi parmi le groupe constitué de sélénium de bis(triméthylsilyle), de sélénium de bis(diméthylsilyle), de sélénium de bis(triéthylsilyle), de sélénium de bis(diéthylsilyle), de sélénium de bis(phényldiméthylsilyle), de sélénium de bis(t-butyldiméthylsilyle), de sélénium de diméthylsilylméthyle, de sélénium de diméthylsilylphényle, de sélénium de diméthylsilyl-n-butyle, de sélénium de diméthylsilyl-t-butyle, de sélénium de triméthylsilylméthyle, de sélénium de triméthylsilylphényle, de sélénium de triméthylsilyl-n-butyle, et de sélénium de triméthylsilyl-t-butyle.

4. Procédé selon une quelconque revendication précédente, dans lequel le composé germanium est choisi parmi le groupe constitué de Ge(OBu^{t})₂, Ge(OCH₂CH₂NMe₂)₂, Ge(OCH(Me)CH₂CH₂NMe₂)₂, Ge(OC(Me)₂CH₂CH₂NMe₂)₂, Ge(OCH(Me)CH₂CH₂NEt₂)₂, Ge(OC(Me)₂CH₂CH₂NEt₂)₂, Ge(OCH₂CH₂OMe)₂, Ge(OCH₂CH₂OEt)₂, Ge(OCH₂CH₂OPrⁱ)₂, Ge(OCH(Me)CH₂CH₂OMe)₂, Ge(OCH(Me)CH₂CH₂OEt)₂, Ge(OCH(Me)CH₂CH₂OPrⁱ)₂, Ge(OC(Me)₂CH₂CH₂OMe)₂, Ge(OC(Me)₂CH₂CH₂OEt)₂, Ge(OC(Me)₂CH₂CH₂OPrⁱ)₂, Ge(OCH₂CH₂SMe)₂, Ge(N(Me)CH₂CH₂NMe₂)₂, Ge(N(Me)CH₂CH₂NEt₂)₂.

5. Procédé selon une quelconque revendication précédente, dans lequel le composé métallique est un composé d'antimoine choisi parmi le groupe constitué : de (a) (RO)₃Sb, où R est un groupe alkyle avec de 1 à 10 atomes de carbone sous forme linéaire, ramifiée ou cyclique ; de (b) (R¹R²N)₃Sb, où R¹ et R² sont chacun indépendamment choisi parmi le groupe constitué de groupes alkyle avec de 1 à 10 atomes de carbone sous forme linéaire, ramifiée ou cyclique ; et de (c) halogénure d'antimoine avec la formule générale : SbX₃ ou SbX₅, où X est F, Cl, ou Br.

6. Procédé selon la revendication 5, le composé d'antimoine est choisi parmi le groupe constitué de Sb(OMe)₃, de Sb(OEt)₃, de Sb(NMe₂)₃, de Sb(NMeEt)₃, et de Sb(NEt₂)₂.

7. Procédé selon une quelconque revendication précédente, dans lequel le procédé est choisi parmi le groupe constitué des procédés de dépôt de couche atomique (ALD), des procédés de dépôt chimique en phase vapeur (CVD) et de chimie humide des solutions.

8. Procédé selon une quelconque revendication précédente, dans lequel le film d'alliage de chalcogénure métallique est à base de germanium-antimoine-tellure avec une composition de Ge₂Sb₂Te₅.

9. Procédé selon une quelconque revendication précédente, dans lequel le procédé est un procédé ALD de fabrication d'un film d'alliage de chalcogénure métallique sur un substrat dans un réacteur ALD comprenant les étapes de :
(a) mise en contact du substrat avec un silyl-chalcogène choisi parmi le groupe constitué de silyle de tellures et de silyle de séléniums ; et
(b) mise en contact du substrat avec un composé germanium représenté par une formule générale choisie parmi le groupe constitué de Ge(OR)₂, Ge(NR₂)₂ et des combinaisons de celles-ci ;
dans laquelle chaque R est indépendamment choisi parmi le groupe constitué d'un groupe alkyle ayant de 1 à 10 atomes de carbone sous forme linéaire, ramifiée ou cyclique, ou un groupe aromatique ; et
d'un groupe alkyle fonctionnalisé avec la structure générale suivante :
R⁵NR⁶R⁷ ;
R⁵OR⁶ ;
ou
R⁵SR⁶ ;
dans laquelle R⁵ est un groupe alkylène ayant de 2 à 6 atomes de carbone sous forme linéaire, ramifiée ou cyclique, ou un groupe aromatique ; et R⁶⁻⁷ sont chacun indépendamment choisi parmi le groupe constitué d'hydrogène, de groupes alkyle ayant de 1 à 6 atomes de carbone sous forme linéaire, ramifiée ou cyclique, et des groupes aromatiques ;
(c) mise en contact du substrat avec un silyl-chalcogène choisi parmi le groupe constitué de silyle de tellures et de silyle de séléniums ;
(d) mise en contact du substrat avec un composé métallique représenté par une formule générale suivante :
MXₙ ;
dans lequel M est choisi parmi le groupe constitué de Sb, In, Sn, Ga, Bi, Ag, Cu, Zr, Hf, Hg, Cd, Zn et des métaux nobles ; X est un groupe nucléophile choisi parmi le groupe constitué de OR(alcoxy), de F(fluor), de Cl(chlore), de Br(brome), de NR₂(amino), de CN(cyano), de OCN(cyanate), de SCN(thiocyanate), de dicétonate, de groupes carboxyliques et des mélanges de ceux-ci ; et n = 1 à 5 ; dans lequel
lorsque n > 1, chaque X est individuellement choisi parmi le groupe constitué de OR(alcoxy), de F(fluor), de Cl(chlore), de Br(brome), de NR₂(amino), de CN(cyano), de OCN(cyanate), de SCN(thiocyanate), de dicétonate, et de groupes carboxyliques ;
(e) éventuellement, purge du réacteur ALD avec un gaz inerte choisi parmi le groupe constitué de N₂, de Ar et des mélanges de ceux-ci ;
dans lequel l'étape de purge (e) est réalisée avant l'étape de mise en contact (a) et après chaque étape de mise en contact ; et
(f) toutes les étapes sont répétées pour atteindre une épaisseur souhaitée du film.

10. Procédé selon une quelconque revendication précédente, dans lequel le procédé est un procédé CVD de fabrication d'un film d'alliage de chalcogénure métallique sur un substrat dans un réacteur CVD comprenant les étapes de :
(a) mise en contact du substrat avec un silyl-chalcogène choisi parmi le groupe constitué de silyle de tellures et de silyle de séléniums ;
(b) mise en contact du substrat avec un composé germanium représenté par une formule générale choisie parmi le groupe constitué de Ge(OR)₂, Ge(NR₂)₂ et des combinaisons de celles-ci ;
dans lequel chaque R est indépendamment choisi parmi le groupe constitué d'un groupe alkyle ayant de 1 à 10 atomes de carbone sous forme linéaire, ramifiée ou cyclique, ou un groupe aromatique ; et
d'un groupe alkyle fonctionnalisé avec la structure générale suivante :
R⁵NR⁶R⁷ ;
R⁵OR⁶ ;
ou
R⁵SR⁶ ;
dans lequel R⁵ est un groupe alkylène ayant de 2 à 6 atomes de carbone sous forme linéaire, ramifiée ou cyclique, ou un groupe aromatique ; et R⁶⁻⁷ sont chacun indépendamment choisi parmi le groupe constitué d'hydrogène, de groupes alkyle ayant de 1 à 6 atomes de carbone sous forme linéaire, ramifiée ou cyclique, et des groupes aromatiques ;
(c) mise en contact du substrat avec un composé métallique représenté par une formule générale suivante :
MXₙ ;
dans lequel M est choisi parmi le groupe constitué de Sb, In, Sn, Ga, Bi, Ag, Cu, Zr, Hf, Hg, Cd, Zn et des métaux nobles ; X est un groupe nucléophile choisi parmi le groupe constitué de OR(alcoxy), de F(fluor), de Cl(chlore), de Br(brome), de NR₂(amino), de CN(cyano), de OCN(cyanate), de SCN(thiocyanate), de dicétonate, de groupes carboxyliques et des mélanges de ceux-ci ; et n = 1 à 5 ; dans lequel
lorsque n > 1, chaque X est individuellement choisi parmi le groupe constitué de OR(alcoxy), de F(fluor), de Cl(chlore), de Br(brome), de NR₂(amino), de CN(cyano), de OCN(cyanate), de SCN(thiocyanate), de dicétonate, et de groupes carboxyliques ;
(d) purge du réacteur CVD avec un gaz inerte choisi parmi le groupe constitué de N₂, de Ar et des mélanges de ceux-ci ; et
(e) pompage du réacteur CVD jusqu'à atteindre une pression inférieure à 130 Pa (1 Torr) ;
dans lequel les étapes de mise en contact de (a) à (c) peuvent être réalisées de manière séquentielle ou simultanément
et dans lequel les étapes de purge et de pompage (d) et (e) sont réalisées avant la première étape de mise en contact.
